# EUROPEAN PATENT APPLICATION

(11) **EP 4 092 065 A1**
(43) Date of publication of application: **23.11.2022**
(21) Application number: 21741770.8
(22) Date of filing: 06.01.2021
(51) Int. Cl.: C08G 59/42, C08L 23/26, C08L 63/00, C08K 3/36, C09J 7/35, H05K 1/03

(54) **RESIN COMPOSITION**

(30) Priority: 16.01.2020 JP 2020005403
(71) Applicant: Sumitomo Seika Chemicals Co., Ltd., Kako-gun, Hyogo 675-0145 (JP)
(72) Inventor: HARISAKI, Ryota, Kako-gun, Hyogo 675-0145 (JP)
(74) Representative: Vossius & Partner Patentanwälte Rechtsanwälte mbB
(86) International application number: PCT/JP2021/000148
(87) International publication number: WO 2021/145241

(57) **Abstract**

Provided is a resin composition having excellent dielectric characteristics, i.e., low dielectric characteristics, in the high-frequency region, and excellent dielectric characteristics, i.e., low dielectric characteristics, under high humidity, and having practical adhesion to metal and resin substrates. More specifically, provided is a resin composition comprising an acid-modified polyolefin, an epoxy resin, and an inorganic filler, wherein a cured product of the resin composition has a dielectric loss tangent of 0.003 or less at a frequency of 10 GHz at 25°C after storage for 168 hours under conditions of 85°C and 85% RH (relative humidity).

## Description

### Technical Field

The present disclosure relates to, for example, a resin composition and use of the resin composition.

### Background Art

With an increase in the transmission signal speed in flexible printed circuit boards (FPCs), signal frequencies are recently increasing. This has led to further demand for FPC materials with low dielectric characteristics (low relative dielectric constant and/or low dielectric loss tangent) in the high-frequency region. To satisfy such a demand, substrate films of liquid crystalline polymer (LCP), syndiotactic polystyrene (SPS), polyphenylene sulfide (PPS), etc. with low dielectric characteristics have been proposed as substrate films for use in FPCs, as alternatives to those of conventional polyimide (PI) and polyethylene terephthalate.

However, since substrate films with low dielectric characteristics are of low polarity, and since conventional epoxy-based adhesives and acrylic-based adhesives have weak adhesive force, production of FPC components, such as coverlay films and laminated sheet, is difficult with the use of conventional epoxy-based adhesives or acrylic-based adhesives. Furthermore, epoxy-based adhesives and acrylic-based adhesives do not have excellent dielectric characteristics, i.e., do not have low dielectric characteristics, and thus impair the dielectric characteristics of FPCs. Therefore, the development of resin adhesives with excellent dielectric characteristics, i.e., low dielectric characteristics, is also in demand.

For example, Patent Literature (PTL) 1 discloses a resin composition containing a polyimide compound, modified polybutadiene, and an inorganic filler. This resin composition has excellent dielectric characteristics, i.e., low dielectric characteristics.

Further, for example, PTL 2 discloses a composition containing crystalline acid-modified polyolefin and an amorphous polyolefin, and a carbodiimide resin or an epoxy resin. This composition exhibits excellent dielectric characteristics, i.e., low dielectric characteristics, and high adhesion to resin substrates and metal substrates.

Further, for example, PTL 3 discloses a resin composition containing a styrene polymer, a curing agent, and an inorganic filler. This resin composition has excellent dielectric characteristics and adhesion to substrates.

### Citation List

### Patent Literature

PTL 1: JP2016-135859A
PTL 2: WO 2016/031342
PTL 3: JP2018-135506A

### Summary of Invention

### Technical Problem

However, the resin composition disclosed in PTL 1 contains a polyimide compound, and thus has high water absorption. Therefore, under high humidity, the resin composition has unsatisfactory dielectric characteristics and cannot propagate the transmission signal properly.

Further, PTL 2 nowhere discloses the dielectric characteristics of the resin composition in the high-frequency region and also nowhere discloses reliability in terms of the dielectric characteristics under high humidity.

Although the resin composition disclosed in PTL 3 has excellent reliability in terms of dielectric characteristics under high humidity, the dielectric characteristics and adhesion in high-frequency applications are insufficient.

Accordingly, a resin composition having excellent dielectric characteristics, i.e., low dielectric characteristics, in the high-frequency region, and excellent dielectric characteristics, i.e., low dielectric characteristics, under high humidity, and having practical adhesion to metal and resin substrates, is in demand.

### Solution to Problem

As a result of extensive research, the present inventor found the possibility that a specific resin composition comprising an acid-modified polyolefin, a specific epoxy resin, and an inorganic filler has excellent dielectric characteristics, i.e., low dielectric characteristics, in the high-frequency region, and excellent dielectric characteristics, i.e., low dielectric characteristics, under high humidity, and has practical adhesion to metal and resin substrates. The inventor then conducted further research.

The present disclosure encompasses, for example, the subject matter described in the following items.
Item 1. A resin composition comprising an acid-modified polyolefin, an epoxy resin, and an inorganic filler, wherein a cured product of the resin composition has a dielectric loss tangent of 0.003 or less at a frequency of 10 GHz at 25°C after storage for 168 hours under conditions of 85°C and 85% RH (relative humidity).
Item 2. The resin composition according to Item 1, wherein the inorganic filler is silica.
Item 3a. The resin composition according to Item 1 or 2, wherein the epoxy resin is at least one member selected from the group consisting of bisphenol A epoxy resins, biphenyl epoxy resins, dicyclopentadiene epoxy resins, anthracene epoxy resins, and silicon element-containing epoxy resins.
Item 3b. The resin composition according to Item 1 or 2,
   wherein the epoxy resin is at least one epoxy resin selected from the group consisting of an epoxy resin represented by formula (1-iia): 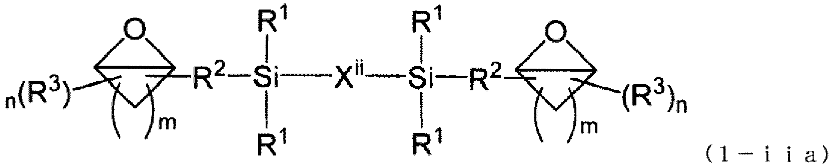 wherein Xⁱⁱ is a divalent group obtained by removing two hydrogen atoms from a saturated hydrocarbon ring or an unsaturated hydrocarbon ring, or from rings having a structure in which 2 to 6 saturated hydrocarbon rings and/or unsaturated hydrocarbon rings are condensed; or a divalent group represented by formula (2^{g}-iia) : 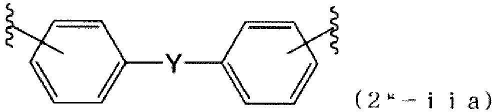 wherein Y is a bond, a C₁₋₆ alkylene group that may be substituted with a C₁₋₄ alkyl group, an oxygen atom (-O-), a sulfur atom (-S-), -SO-, or -SO₂-;
   R¹ is the same or different, and is a C₁₋₁₈ alkyl group, a C₂₋₉ alkenyl group, a cycloalkyl group, an aryl group, or an aralkyl group, wherein one or more carbon atoms of these groups may be replaced by at least one atom selected from the group consisting of an oxygen atom and a nitrogen atom;
   R² is the same or different, and is a C₁₋₁₈ alkylene group, wherein one or more carbon atoms of this group other than a carbon atom directly bonded to a silicon atom may be replaced by at least one atom selected from the group consisting of an oxygen atom and a nitrogen atom;
   R³ is the same or different, and is a C₁₋₁₈ alkyl group, a C₂₋₉ alkenyl group, a cycloalkyl group, an aryl group, or an aralkyl group, wherein one or more carbon atoms of these groups may be replaced by at least one atom selected from the group consisting of an oxygen atom and a nitrogen atom;
   m is an integer of 0 to 6; and
   n is an integer of 0 to 3;
   an epoxy resin represented by formula (1-iiia): 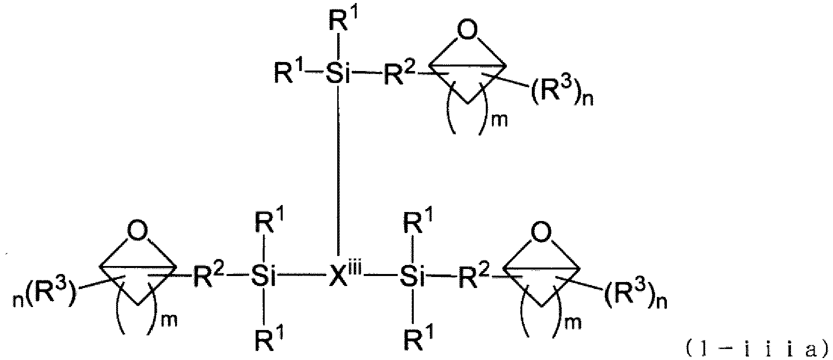 wherein Xⁱⁱⁱ is a trivalent group obtained by removing three hydrogen atoms from a saturated hydrocarbon ring or an unsaturated hydrocarbon ring, or from rings having a structure in which 2 to 6 saturated hydrocarbon rings and/or unsaturated hydrocarbon rings are condensed; or a trivalent group represented by formula (2^{g}-iiia): 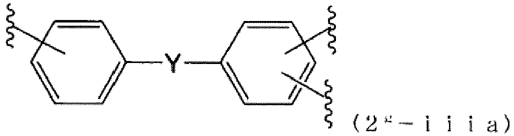 wherein Y is as defined above; and
   R¹, R², R³, m, and n are as defined above; and an epoxy resin represented by formula (1-iva): 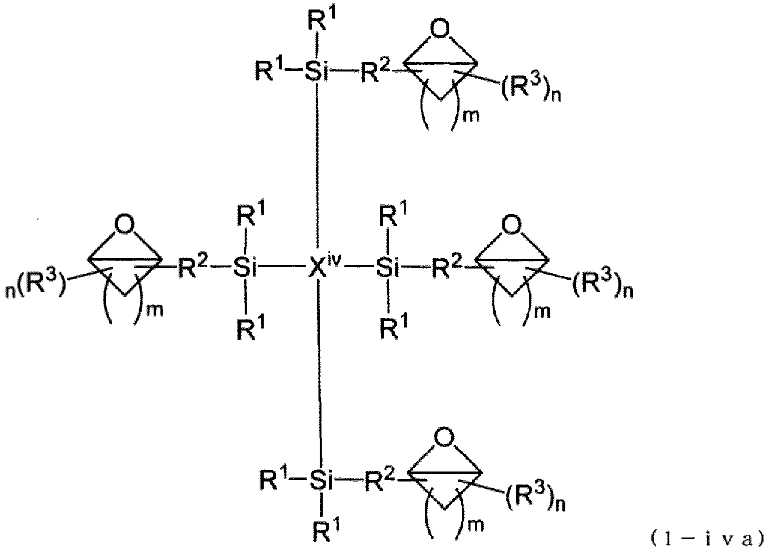 wherein X^{iv} is a tetravalent group obtained by removing four hydrogen atoms from a saturated hydrocarbon ring or an unsaturated hydrocarbon ring, or from rings having a structure in which 2 to 6 saturated hydrocarbon rings and/or unsaturated hydrocarbon rings are condensed; or a tetravalent group represented by formula (2^{g}): 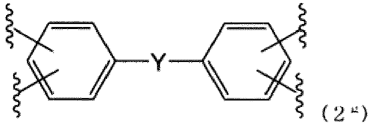 wherein Y is as defined above; and
   R¹, R², R³, m, and n are as defined above.
Item 4. The resin composition according to any one of Items 1 to 3b, wherein the epoxy resin is an epoxy resin whose cured product has a dielectric loss tangent of 0.03 or less at a frequency of 10 GHz at 25°C.
Item 5. The resin composition according to any one of Items 1 to 4, further comprising a curing agent.
Item 6. The resin composition according to any one of Items 1 to 5, wherein the total mass of the epoxy resin and the curing agent is 9 parts by mass or less based on 100 parts by mass of the total mass of the acid-modified polyolefin, the epoxy resin, and the curing agent.
Item 7. An adhesive film containing the resin composition of any one of Items 1 to 6.
Item 8. The adhesive film according to Item 7, wherein the resin composition is a cured product and has a thickness of 2 to 200 µm.
Item 9. A coverlay film having a laminated structure in which an adhesive layer containing the resin composition of any one of Items 1 to 6 and an electrical insulating layer are laminated. Item 10.

A printed circuit board having a laminated structure in which an adhesive layer containing the resin composition of any one of Items 1 to 6 and an electrical insulating layer are laminated.

### Advantageous Effects of Invention

Provided is a resin composition having excellent dielectric characteristics, i.e., low dielectric characteristics, in the high-frequency region, and excellent dielectric characteristics, i.e., low dielectric characteristics, under high humidity, and having practical adhesion to metal and resin substrates. Such a resin composition is advantageous for use as, for example, an adhesive or an adhesive film for coverlay films or printed circuit boards since the composition has low dielectric characteristics in the high-frequency region and has excellent dielectric characteristics under high humidity, while having excellent adhesion. In particular, the resin composition is suitable for use in, for example, coverlay films and printed circuit boards, which are used in high-frequency bands (e.g., 1 GHz or more).

### Description of Embodiments

Each embodiment encompassed by the present disclosure is described in more detail below. The present disclosure preferably encompasses a resin composition comprising an acid-modified polyolefin, a specific epoxy resin, and an inorganic filler, and use of the resin composition. However, the present disclosure is not limited thereto and includes everything disclosed in the present specification and recognizable to those skilled in the art.

The resin composition encompassed by the present disclosure comprises an acid-modified polyolefin, a specific epoxy resin, and an inorganic filler, as described above. The resin composition encompassed by the present disclosure may be referred to below as "the resin composition of the present disclosure."

### Acid-modified Polyolefin

Examples of acid-modified polyolefins include a polyolefin modified with an acid-modified group, such as a carboxyl group and an acid anhydride group. In particular, a polyolefin modified with a carboxyl group is preferred. In the present specification, "carboxyl group" represents a concept that also includes "anhydrous carboxyl groups," unless otherwise specified.

Specific preferable examples of the acid-modified polyolefin include an acid-modified polyolefin obtained by grafting a polyolefin with an acid-modified group (an acid-modified group-grafted acid-modified polyolefin), an acid-modified polyolefin obtained by copolymerizing an olefin and at least one member selected from the group consisting of an unsaturated carboxylic acid and an acid anhydride thereof (an acid-modified group-copolymerized acid-modified polyolefin), acid-modified polyolefins obtained by further hydrogenating these acid-modified polyolefins (a hydrogenated acid-modified group-grafted acid-modified polyolefin and a hydrogenated acid-modified group-copolymerized acid-modified polyolefin), and the like. It is more preferable that the acid-modified group-grafted acid-modified polyolefin and the acid-modified polyolefin copolymerized with an acid-modified group do not have an unsaturated bond in their main chain.

Preferable examples of the polyolefin in the acid-modified polyolefin grafted with an acid-modified group (in other words, the polyolefin before the polyolefin is grafted with an acid-modified group) include polyethylene, polypropylene, and an olefin copolymer.

Examples of olefin copolymers include propylene-α-olefin copolymers, olefin-cyclic olefin copolymers, olefin-styrene copolymers, and the like.

Propylene-α-olefin copolymers are obtained by copolymerization of propylene and α-olefins. Examples of α-olefins include ethylene, 1-butene, 1-heptene, 1-octene, 4-methyl-1-pentene, and the like. These α-olefins can be used singly or in a combination of two or more. Further, other monomers, such as vinyl acetate, may be combined and copolymerized. Examples of olefin-cyclic olefin copolymers include copolymers of ethylene or propylene, and tetracyclododecene, and the like.

Examples of olefin-styrene copolymers include a styrene-butadiene copolymer, a styrene-ethylene propylene copolymer, a styrene-butadiene-styrene copolymer, a styreneisoprene-styrene copolymer, a styrene-ethylene butylene-styrene copolymer, a styrene-ethylene propylene-styrene copolymer, and the like.

The method for producing the acid-modified polyolefin grafted with an acid-modified group is not particularly limited, and a known method can be used. For example, radical graft reaction of polyolefins can be used. More specifically, for example, a radical species is generated in a polymer serving as a main chain, and unsaturated carboxylic acid and/or unsaturated carboxylic anhydride is graft-polymerized using the radical species as a polymerization starting point.

Examples of the unsaturated carboxylic acid and/or unsaturated carboxylic anhydride include unsaturated monocarboxylic acids, such as acrylic acid, butanoic acid, crotonic acid, vinylacetic acid, methacrylic acid, pentenoic acid, dodecenoic acid, linoleic acid, angelic acid, and cinnamic acid; unsaturated dicarboxylic acids, such as maleic acid, fumaric acid, chloromaleic acid, and himic acid; unsaturated carboxylic anhydrides, such as maleic anhydride, himic anhydride, and acrylic anhydride; and the like. Among these, maleic anhydride can be particularly suitably used.

The number average molecular weight of the acid-modified polyolefin is preferably, for example, 2000 to 300000, and more preferably 3000 to 200000. Moreover, the equivalent ratio of epoxy groups in the epoxy resin to acid-modified groups in the acid-modified polyolefin (particularly when it is an acid-modified polyolefin with a number average molecular weight of 20000 or less) (epoxy groups/acid-modified groups) in the epoxy resin composition is preferably about 0.5 to 6 in terms of heat resistance. The lower limit is more preferably 0.5, and still more preferably 0.8, and the upper limit is more preferably 6, and still more preferably 3. The number average molecular weight is measured by gel permeation chromatography (GPC). The number average molecular weight of the acid-modified polyolefin is determined by comparison with polystyrene with known number average molecular weight measured under the same conditions by GPC.

The acid value (mgKOH/g) of the acid-modified polyolefin is not particularly limited, and is preferably 0.5 to 500, and more preferably 2 to 300.

The functional group equivalent (g/mol) of the acid-modified group of the acid-modified polyolefin is preferably 100 to 50000, and more preferably 200 to 30000.

The content of the acid-modified polyolefin in the resin composition is not particularly limited, and may be, for example, about 70 to 98 mass%, and preferably about 80 to 98, 85 to 98, or 90 to 98 mass%.

The relative dielectric constant of the acid-modified polyolefin at a frequency of 10 GHz at 25°C is preferably 3.0 or less, more preferably 2.8 or less, and even more preferably 2.6 or less. The dielectric loss tangent of the acid-modified polyolefin at a frequency of 10 GHz at 25°C is preferably 0.003 or less, more preferably 0.0028 or less, and even more preferably 0.0025 or less. The relative dielectric constant and the dielectric loss tangent of the acid-modified polyolefin are measured by a cavity resonator perturbation method.

The acid-modified polyolefins can be used singly or in a combination of two or more.

### Epoxy Resin

The resin composition of the present disclosure comprises an epoxy resin. The epoxy resin can react with the acid-modified group (e.g., a carboxyl group) in the acid-modified polyolefin, thus increasing the crosslinking density and improving adhesion and solder reflow resistance of the resulting resin composition.

Examples of epoxy resins include compounds having two or more (preferably two, three, or four) epoxy groups per molecule. The epoxy resins are preferably those that are usable for electrical and electronic materials. Specific examples include bisphenol A epoxy resins, bisphenol F epoxy resins, bisphenol S epoxy resins, phenol novolak epoxy resins, cresol novolak epoxy resins, cycloaliphatic epoxy resins, nitrogen ringcontaining epoxy resins (e.g., triglycidyl isocyanurate), hydantoin epoxy resins, aliphatic epoxy resins, glycidyl ether epoxy resins, biphenyl epoxy resins, dicyclopentadiene epoxy resins, naphthalene epoxy resins, anthracene epoxy resin, special epoxy resins (e.g., silicon element-containing epoxy resins), and the like. These resins may be halogenated or hydrogenated.

Preferred are bisphenol A epoxy resins, biphenyl epoxy resins, dicyclopentadiene epoxy resins, anthracene epoxy resins, and silicon element-containing epoxy resins from the viewpoint of improving dielectric characteristics (in particular, reducing the dielectric loss tangent) of the cured product. More preferred are silicon element-containing epoxy resins represented by the following formula (1). These epoxy resins may be used alone or in a combination of two or more.

Specific examples of bisphenol A epoxy resins include jER828 and jER828EL (both produced by Mitsubishi Chemical Corporation), EPICLON840 and EPICLON860 (both produced by DIC Corporation), and the like. Specific examples of biphenyl epoxy resins include YX4000 and YL6677 (both produced by Mitsubishi Chemical Corporation), NC-3000 and NC-3000-H (both produced by Nippon Kayaku Co., Ltd.), and the like. Specific examples of dicyclopentadiene epoxy resins include HP-7200, HP-7200L, and HP-7200H (all produced by DIC Corporation), ND-1000 (produced by Nippon Kayaku Co., Ltd.), and the like. Specific examples of anthracene epoxy resins include YX8800 (produced by Mitsubishi Chemical Corporation) and the like. Specific examples of silicon element-containing epoxy resins include epoxy resins represented by formula (1) and the like.

Examples of epoxy resins that can be preferably used in the epoxy resin composition of the present disclosure include epoxy resins represented by formula (1):

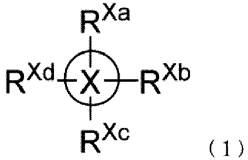

In formula (1), R^{Xa}, R^{Xb}, R^{Xc}, and R^{Xd} are the same or different, and each is a hydrogen atom, a lower alkyl group, a lower alkoxy group, a lower alkenyl group, a halogen atom, or a group represented by formula (3): 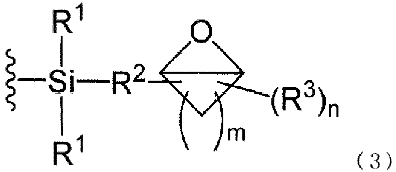 (hereinafter also referred to as the "group of formula (3)"). Hereinafter, a lower alkyl group, a lower alkoxy group, and a lower alkenyl group are also collectively referred to as "lower carbon substituents." In the present disclosure, among the lower carbon substituents, a lower alkyl group or a lower alkoxy group is more preferable.

However, at least one of R^{Xa}, R^{Xb}, R^{Xc}, and R^{Xd} is a group of formula (3). In other words, three of R^{Xa}, R^{Xb}, R^{Xc}, and R^{Xd} are hydrogen atoms, halogen atoms, or lower carbon substituents, and the other one is a group of formula (3); two of them are hydrogen atoms, halogen atoms, or lower carbon substituents, and the other two are groups of formula (3); one of them is a hydrogen atom, a halogen atom, or a lower carbon substituent, and the other three are groups of formula (3); or all of them are groups of formula (3). More specifically, for example, R^{Xa}, R^{Xb}, R^{Xc}, and R^{Xd} may be as follows:
(i) R^{Xa}, R^{Xb}, and R^{Xc} are hydrogen atoms, halogen atoms, or lower carbon substituents, and R^{Xd} is a group of formula (3);
(ii) R^{Xa} and R^{Xb} are hydrogen atoms, halogen atoms, or lower carbon substituents, and R^{Xc} and R^{Xd} are groups of formula (3);
(iii) R^{Xa} is a hydrogen atom, a halogen atom, or a lower carbon substituent, and R^{Xb}, R^{Xc}, and R^{Xd} are groups of formula (3); or
(iv) all of R^{Xa}, R^{Xb}, R^{Xc}, and R^{Xd} are groups of formula (3) .
Of R^{Xa}, R^{Xb}, R^{Xc}, and R^{Xd}, one or more members that are not groups of formula (3) are more preferably hydrogen atoms or lower carbon substituents.

In formula (1), R^{Xa}, R^{Xb}, R^{Xc}, and R^{Xd} may be the same or different. Therefore, (i) when R^{Xa}, R^{Xb}, and R^{Xc} are hydrogen atoms, halogen atoms, or lower carbon substituents, and when R^{Xd} is a group of formula (3), R^{Xa}, R^{Xb}, and R^{Xc} may be the same or different. (ii) When R^{Xa} and R^{Xb} are hydrogen atoms, halogen atoms, or lower carbon substituents, and when R^{Xc} and R^{Xd} are groups of formula (3), R^{Xa} and R^{Xb} may be the same or different, and R^{Xc} and R^{Xd} may also be the same or different. (iii) When R^{Xa} is a hydrogen atom, a halogen atom, or a lower carbon substituent, and when R^{Xb}, R^{Xc}, and R^{Xd} are groups of formula (3), R^{Xb}, R^{Xc}, and R^{Xd} may be the same or different. (iv) When all of R^{Xa}, R^{Xb}, R^{Xc}, and R^{Xd} are groups of formula (3), R^{Xa}, R^{Xb}, R^{Xc}, and R^{Xd} may be the same or different. In any of these cases, the groups of formula (3) are preferably the same.

Moreover, when two or three of R^{Xa}, R^{Xb}, R^{Xc}, and R^{Xd} are halogen atoms or lower carbon substituents, these halogen atoms or lower carbon substituents may also be the same or different. In this case, two or three of R^{Xa}, R^{Xb}, R^{Xc}, and R^{Xd} are more preferably the same lower carbon substituents.

In the present specification, the lower carbon substituent refers to a lower alkyl group, a lower alkoxy group, or a lower alkenyl group. The term "lower" used herein means 1 to 6 (1, 2, 3, 4, 5, or 6) carbon atoms. Of the lower carbon substituents, a lower alkyl group or a lower alkoxy group is preferable. Specifically, preferable examples of lower alkyl groups include a methyl group, an ethyl group, an n-propyl group, an isopropyl group, an n-butyl group, an isobutyl group, and the like. Preferable examples of lower alkoxy groups include a methoxy group, an ethoxy group, a propoxy group, an isopropoxy group, a butoxy group, an isobutoxy group, and the like.

Moreover, in the present specification, the halogen atom is a fluorine atom, a chlorine atom, a bromine atom, or an iodine atom; preferably a fluorine atom, a chlorine atom, or a bromine atom; and more preferably a fluorine atom or a bromine atom.

In formula (1), X ring is a saturated hydrocarbon ring or an unsaturated hydrocarbon ring, or rings having a structure in which 2 to 6 saturated hydrocarbon rings and/or unsaturated hydrocarbon rings are condensed, or in which 2 saturated hydrocarbon rings and/or unsaturated hydrocarbon rings are connected. In the present specification, the saturated hydrocarbon ring is, for example, preferably a C₄₋₈ (4, 5, 6, 7, or 8) saturated hydrocarbon ring, and particularly preferably a cyclopentane ring, a cyclohexane ring, or the like. In the present specification, the unsaturated hydrocarbon ring is, for example, preferably a C₄₋₈ (4, 5, 6, 7, or 8) unsaturated hydrocarbon ring, and particularly preferably a benzene ring or the like. In the present specification, the rings having a structure in which 2 to 6 saturated hydrocarbon rings and/or unsaturated hydrocarbon rings are condensed are preferably 2, 3, or 4 condensed saturated hydrocarbon rings and/or unsaturated hydrocarbon rings, and more preferably 2 or 3 condensed saturated hydrocarbon rings and/or unsaturated hydrocarbon rings. More specific examples include a decahydronaphthalene ring, an adamantane ring, a naphthalene ring, a phenanthrene ring, an anthracene ring, a pyrene ring, a triphenylene ring, a tetralin ring, 1,2,3,4,5,6,7,8-octahydronaphthalene ring, a norbornene ring, and the like.

In the present specification, a saturated hydrocarbon ring or an unsaturated hydrocarbon ring, or rings having a structure in which 2 to 6 saturated hydrocarbon rings and/or unsaturated hydrocarbon rings are condensed, are also collectively referred to as "hydrocarbon rings."

The rings having a structure in which 2 saturated hydrocarbon rings and/or unsaturated hydrocarbon rings are connected are preferably rings represented by formula (2):

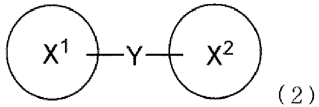

In formula (2), X¹ ring and X² ring are the same or different, and each is a saturated hydrocarbon ring or an unsaturated hydrocarbon ring. That is, the X¹ ring and X² ring are both saturated hydrocarbon rings or unsaturated hydrocarbon rings; or one of them is a saturated hydrocarbon ring, and the other is an unsaturated hydrocarbon ring. It is preferable that the X¹ ring and the X² ring both be saturated hydrocarbon rings or unsaturated hydrocarbon rings. For example, it is preferable that the X¹ ring and the X² ring both be benzene rings or cyclohexane rings, or that one of them be a benzene ring and the other be a cyclohexane ring; and it is more preferable that both of them be benzene rings.

Moreover, Y is a bond, a C₁₋₆ alkylene group that may be substituted with a C₁₋₄ alkyl group, an oxygen atom (-O-), a sulfur atom (-S-), -SO-, or -SO₂-. Examples of the C₁₋₆ alkylene group include a methylene group, an ethylene group, a trimethylene group, a tetramethylene group, a hexamethylene group, and the like. Moreover, examples of the C₁₋₄ alkyl group as a substituent include a methyl group, an ethyl group, an n-propyl group, an isopropyl group, an n-butyl group, an isobutyl group, and the like. Preferable examples of the C₁₋₆ alkylene group substituted with a C₁₋₄ alkyl group include -CH(CH₃)-, -C(CH₃)₂-, -CH₂CH(CH₃)CH₂-, -CH₂C(CH₃)₂CH₂-, and the like. Y is preferably a bond, an oxygen atom, a methylene group, a dimethylmethylene group, -S-, or -SO₂-; and more preferably a bond, a dimethylmethylene group, an oxygen atom, or -SO₂-.

The rings represented by formula (2) are substituted with R^{Xa}, R^{Xb}, R^{Xc}, and R^{Xd}. When the X ring of formula (1) is rings represented by formula (2), when three of R^{Xa} to R^{Xd} are hydrogen atoms, halogen atoms, or lower carbon substituents, and when the other one is a group of formula (3), one of the X¹ ring and X² ring may be substituted with a group of formula (3). In this case, the rings represented by formula (2) are substituted with 0, 1, 2, or 3 halogen atoms or lower carbon substituents, and (number of halogen atoms or lower carbon substituents substituted in X¹ ring : number of halogen atoms or lower carbon substituents substituted in X² ring) can be (1:0), (0:1), (2:0), (1:1), (0:2), (3:0), (2:1), (1:2), or (0:3). When two of R^{Xa} to R^{Xd} are hydrogen atoms, halogen atoms, or lower carbon substituents, and when the other two are groups of formula (3), one of the X¹ ring and X² ring may be substituted with 2 groups of formula (3), or the X¹ ring and the X² ring each may be substituted with a group of formula (3). It is preferable that the X¹ ring and the X² ring each be substituted with a group of formula (3). In this case, the rings represented by formula (2) are substituted with 0, 1, or 2 halogen atoms or lower carbon substituents, and (number of halogen atoms or lower carbon substituents substituted in X¹ ring : number of halogen atoms or lower carbon substituents substituted in X² ring) can be (1:0), (0:1), (2:0), (1:1), or (0:2). When one of R^{Xa} to R^{Xd} is a hydrogen atom, a halogen atom, or a lower carbon substituent, and when the other three are groups of formula (3), one of the X¹ ring and X² ring may be substituted with 3 groups of formula (3); the X¹ ring may be substituted with 2 groups of formula (3), and the X² ring may be substituted with 1 group of formula (3); or the X¹ ring may be substituted with 1 group of formula (3), and the X² ring may be substituted with 2 groups of formula (3). It is preferable that the X¹ ring be substituted with 2 groups of formula (3), and the X² ring be substituted with 1 group of formula (3); or that the X¹ ring be substituted with 1 group of formula (3), and the X² ring be substituted with 2 groups of formula (3). In this case, the rings represented by formula (2) are substituted with 0 or 1 halogen atom or lower carbon substituent, and (number of halogen atoms or lower carbon substituents substituted in X¹ ring : number of halogen atoms or lower carbon substituents substituted in X² ring) may be (1:0) or (0:1). When all of R^{Xa} to R^{Xd} are groups of formula (3), one of the X¹ ring and the X² ring may be substituted with 4 groups of formula (3); the X¹ ring may be substituted with 3 groups of formula (3), and the X² ring may be substituted with 1 group of formula (3); the X¹ ring may be substituted with 1 group of formula (3), and the X² ring may be substituted with 3 groups of formula (3); or the X¹ ring may be substituted with 2 groups of formula (3), and the X² ring may be substituted with 2 groups of formula (3). It is preferable that the X¹ ring be substituted with 2 groups of formula (3), and the X² ring be substituted with 2 groups of formula (3).

As a group of formula (1), a tetravalent group represented by formula (1'): 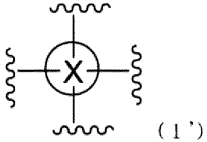 wherein in formula (1'), X ring is as defined above;
is particularly preferably a group represented by the following formula. Specifically, the group is represented by the following formula: 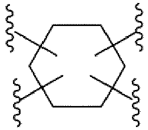 or 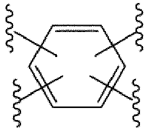 or 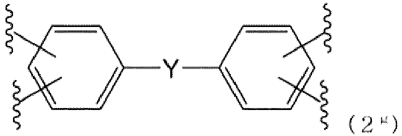 wherein in formula (2^{g}), Y is as defined above.

In formula (3), R¹ is the same or different, and is a C₁₋₁₈ alkyl group, a C₂₋₉ alkenyl group, a cycloalkyl group, an aryl group, or an aralkyl group, wherein one or more carbon atoms of these groups may be replaced by at least one atom selected from the group consisting of an oxygen atom and a nitrogen atom (preferably an oxygen atom). The one or more carbon atoms are preferably carbon atoms that are not directly bonded to the silicon atom. The one or more carbon atoms that may be replaced are one or plural (e.g., 2, 3, 4, 5, or 6) carbon atoms, and preferably one carbon atom. In terms of ease of synthesis etc., it is preferable that R¹ bonded to the same silicon atom be the same. It is more preferable that all R¹ present in formula (1) be the same.

The C₁₋₁₈ alkyl group represented by R¹ is, for example, a linear or branched alkyl group. Examples include a methyl group, an ethyl group, an n-propyl group, an isopropyl group, an n-butyl group, an isobutyl group, a tert-butyl group, an n-pentyl group, a neopentyl group, a tert-pentyl group, an n-hexyl group, an n-heptyl group, a 2,2,4-trimethylpentyl group, an n-octyl group, an isooctyl group, an n-nonyl group, an n-decyl group, an n-dodecyl group, and the like. Preferable is a C₁₋₁₀ alkyl group, more preferable is a C₁₋₆ alkyl group, even more preferable is a C₁₋₃ alkyl group, and particularly preferable is a methyl group.

The C₂₋₉ alkenyl group represented by R¹ is, for example, a linear or branched alkenyl group. Examples include a vinyl group, an allyl group, a 2-propenyl group, a butenyl group, a pentenyl group, a hexenyl group, a heptenyl group, an octenyl group, a nonenyl group, and the like. Preferable is a C₂₋₄ alkenyl group.

The cycloalkyl group represented by R¹ is, for example, a 3- to 8-membered ring cycloalkyl group. Examples include a cyclopentyl group, a cyclohexyl group, a cycloheptyl group, a methylcyclohexyl group, and the like.

The aryl group represented by R¹ is, for example, a monocyclic or bicyclic aryl group. Examples include a phenyl group, a tolyl group, a xylyl group, an ethyl phenyl group, a naphthyl group, and the like. Of these, a phenyl group is preferable.

The aralkyl group represented by R¹ is, for example, a C₁₋₄ alkyl group substituted with an aryl group (particularly a phenyl group). Examples include a benzyl group, an α-phenethyl group, a β-phenethyl group, a β-methylphenethyl group, and the like.

R¹ is preferably a C₁₋₃ alkyl group, and more preferably a methyl group.

In formula (3), R² is a C₁₋₁₈ (C₁, C₂, C₃, C₄, C₅, C₆, C₇, C₈, C₉, C₁₀, C₁₁, C₁₂, C₁₃, C₁₄, C₁₅, C₁₆, C₁₇, or C₁₈) alkylene group. The alkylene group is a linear or branched alkylene group, and preferably a linear alkylene group. Examples include a methylene group, a methylmethylene group, an ethylmethylene group, a dimethylmethylene group, a diethylmethylene group, a dimethylene group (-CH₂CH₂-) , a trimethylene group (-CH₂CH₂CH₂-), a tetramethylene group, a pentamethylene group, a hexamethylene group, a heptamethylene group, an octamethylene group, a nonamethylene group, a decamethylene group, an undecamethylene group, a dodecamethylene group, a tridecamethylene group, and the like. Specific examples include a C₂₋₁₈ alkylene group, preferably a C₂₋₁₀ alkylene group, more preferably a C₂₋₈ alkylene group, even more preferably a C₂₋₆ alkylene group, and particularly preferably a C₂₋₅ alkylene group.

One or more carbon atoms of the C₁₋₁₈ alkylene group may be replaced by at least one atom selected from the group consisting of an oxygen atom and a nitrogen atom (preferably an oxygen atom). The one or more carbon atoms are preferably carbon atoms that are not directly bonded to the silicon atom, and the 3- to 8-membered ring or epoxy ring. Moreover, the one or more carbon atoms that may be replaced are one or plural (e.g., 2, 3, 4, 5, or 6) carbon atoms, and preferably one carbon atom.

When the side of R² binding to the silicon atom is expressed as (*), examples of this group include (*)-C₂₋₉ alkylene-O-C₁₋₈ alkylene-, preferably (*)-C₂₋₄ alkylene-O-C₁₋₃ alkylene-, more preferably (*)-C₂₋₄ alkylene-O-C₁₋₂ alkylene-, and particularly preferably (*)-C₃ alkylene-O-methylene-.

Specific examples include (*)-(CH₂)₂-O-CH₂-, (*)-(CH₂)₃-O-CH₂-, (*)-(CH₂)₃-O-(CH₂)₂-, (*)-(CH₂)₅-O-(CH₂)₄-, and the like; of these, (*)-(CH₂)₃-O-CH₂ is preferable.

In formula (3), m is an integer of 0 to 6 (i.e., 0, 1, 2, 3, 4, 5, or 6). Moreover, n is an integer of 0 to 3 (i.e., 0, 1, 2, or 3). The group bonded to R² of formula (3) (on the side not binding to the silicon atom) is represented by formula (4) (hereafter also referred to as "the group of formula (4)"), as shown below. 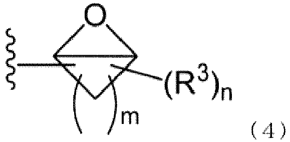 The group of formula (4) wherein m is an integer of 1 to 6 is specifically described by the following structural formulas.

When m = 1,

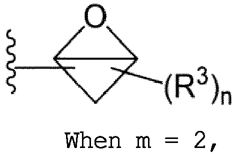

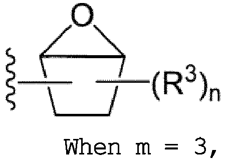

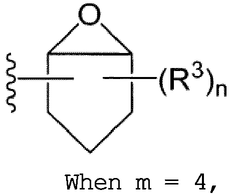

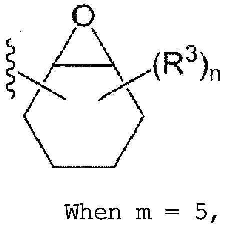

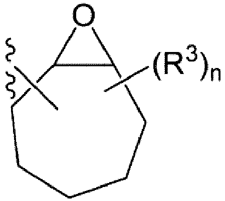

When m = 6,

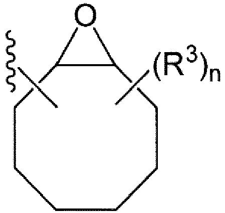

When m is 0, only an epoxy ring remains, and n is an integer of 0 to 3; thus, the group of formula (4) is a group represented by any of the following formulas: 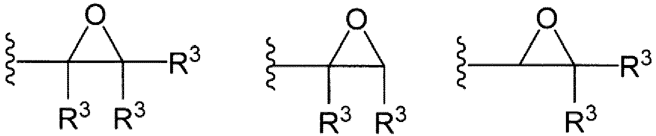 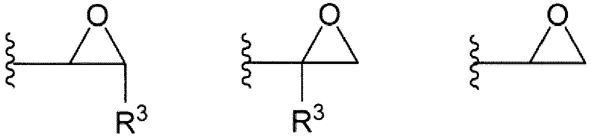 In formula (3), R² and R³ bind to a 3- to 8-membered ring or an epoxy ring. n represents the number of R³ binding to the 3- to 8-membered ring or the epoxy ring.

In formula (3), R³ is the same or different, and is a C₁₋₁₈ alkyl group, a C₂₋₉ alkenyl group, a cycloalkyl group, an aryl group, or an aralkyl group. One or more carbon atoms of these groups may be replaced by at least one atom selected from the group consisting of an oxygen atom and a nitrogen atom. The one or more carbon atoms are preferably carbon atoms that are not directly bonded to the 3- to 8-membered ring or epoxy ring. Moreover, the one or more carbon atoms that may be replaced are one or plural (e.g., 2, 3, 4, 5, or 6) carbon atoms, and preferably one carbon atom.

Examples of the C₁₋₁₈ alkyl group, C₂₋₉ alkenyl group, cycloalkyl group, aryl group, and aralkyl group represented by R³ include the same corresponding substituents represented by R¹ described above.

R³ is preferably a C₁₋₃ alkyl group, and more preferably a methyl group or an ethyl group.

Preferable examples of the group of formula (3) include groups wherein R¹, R², R³, m, and n are as defined above; all R¹ are the same; and all R³ are the same (when there are plural R³). The number of this group present in the epoxy resin represented by formula (1) is 1, 2, 3, or 4; and they may be the same or different, and are preferably the same.

Particularly preferable specific examples of the group of formula (4) include groups wherein R³ is as defined above; m is 0, 1, 2, 3, or 4; and n is 0, 1, or 2. More preferable among these are, for example, the following groups (all R³ are as defined above): 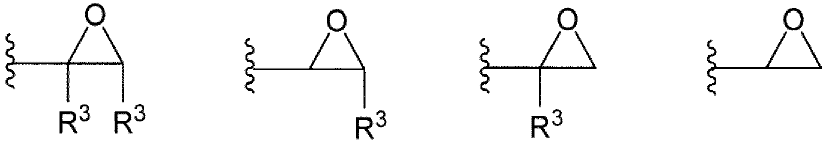 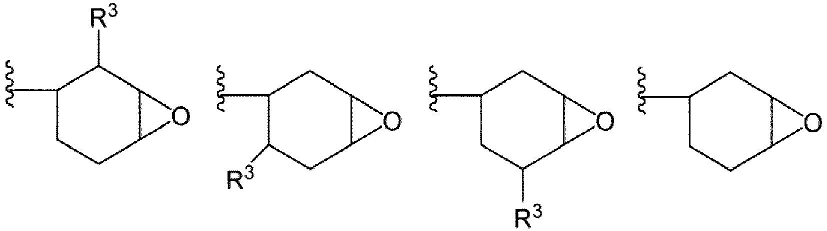 The number of groups of formula (4) present in the epoxy resin represented by formula (1) is 1, 2, 3, or 4; and they may be the same or different, and are preferably the same.

Moreover, one or more hydrogen atoms bonded to one or more carbon atoms that constitute the hydrocarbon ring constituting the X ring, and that are not bonded to R^{Xa}, R^{Xb}, R^{Xc}, or R^{Xd}, may be replaced by a lower carbon substituent or a halogen atom (preferably a lower carbon substituent). That is, when the X ring is a saturated hydrocarbon ring or an unsaturated hydrocarbon ring, or rings having a structure in which 2 to 6 saturated hydrocarbon rings and/or unsaturated hydrocarbon rings are condensed, one or more hydrogen atoms bonded to one or more carbon atoms that constitute these rings, and that are not bonded to R^{Xa}, R^{Xb}, R^{Xc}, or R^{Xd}, may be replaced by a lower carbon substituent or a halogen atom (preferably a lower carbon substituent). When the X ring is rings having a structure in which 2 saturated hydrocarbon rings and/or unsaturated hydrocarbon rings are connected, one or more hydrogen atoms bonded to one or more carbon atoms that constitute these connected saturated hydrocarbon rings and/or unsaturated hydrocarbon rings, and that are not bonded to R^{Xa}, R^{Xb}, R^{Xc}, or R^{Xd}, may be replaced by a lower carbon substituent or a halogen atom (preferably a lower carbon substituent). When the case in which the X ring is rings represented by formula (2) is explained in detail, one or more hydrogen atoms bonded to one or more carbon atoms that constitute the X¹ ring and X² ring, and that are not bonded to R^{Xa}, R^{Xb}, R^{Xc}, or R^{Xd}, may be replaced by a lower carbon substituent or a halogen atom (preferably a lower carbon substituent).

In the present specification, carbon atoms that constitute the hydrocarbon ring constituting the X ring, and that are not bonded to R^{Xa}, R^{Xb}, R^{Xc}, and R^{Xd}, are also referred to as "R^{Xa-d} non-binding carbon atoms."

The lower carbon substituent or halogen atom that may replace one or more hydrogen atoms bonded to one or more R^{Xa-d} non-binding carbon atoms is preferably singly bonded to one R^{Xa-d} non-binding carbon atom. That is, when hydrogen atoms bonded to R^{Xa-d} non-binding carbon atoms are replaced, only one of the hydrogen atoms bonded to the R^{Xa-d} non-binding carbon atoms is preferably replaced by a lower carbon substituent or halogen atom. Moreover, the number of substituents (i.e., the total number of lower carbon substituents and halogen atoms) is more preferably less than the number of R^{Xa-d} non-binding carbon atoms. More specifically, the number of substituents is preferably 1 to 6 (1, 2, 3, 4, 5, or 6), more preferably 1 to 4, and even more preferably 1 or 2. Particularly when the X ring is rings represented by formula (2), one or more hydrogen atoms to be replaced are preferably hydrogen atoms bonded to carbon atoms that are not bonded to Y.

When at least one of R^{Xa}, R^{Xb}, R^{Xc}, and R^{Xd} is a lower carbon substituent, and when at least one lower carbon substituent is bonded to an R^{Xa-d} non-binding carbon atom, all of the lower carbon substituents are preferably the same. That is, when there are lower carbon substituents among R^{Xa}, R^{Xb}, R^{Xc}, and R^{Xd}, and when there are lower carbon substituents bonded to R^{Xa-d} non-binding carbon atoms, all of the lower carbon substituents are preferably the same. Moreover, when at least one of R^{Xa}, R^{Xb}, R^{Xc}, and R^{Xd} is a halogen atom, and when at least one halogen atom is bonded to an R^{Xa-d} non-binding carbon atom, all of the halogen atoms are preferably the same. That is, when there are halogen atoms among R^{Xa}, R^{Xb}, R^{Xc}, and R^{Xd}, and when there are halogen atoms bonded to R^{Xa-d} non-binding carbon atoms, all of the halogen atoms are preferably the same.

More specifically, for example, when the tetravalent group represented by the above formula (1') is the following: 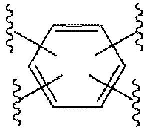 preferable examples of the epoxy resin represented by formula (1) include an epoxy resin represented by formula (1-X1): 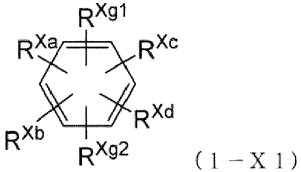 wherein in formula (1-X1), R^{Xa}, R^{Xb}, R^{Xc}, and R^{Xd} are as defined above; and R^{Xg1} and R^{Xg2} are the same or different, and each is a hydrogen atom, a lower alkyl group, a lower alkoxy group, or a lower alkenyl group.

In formula (1-X1), R^{Xa}, R^{Xb}, R^{Xc}, R^{Xd}, R^{Xg1}, and R^{Xg2} are more preferably each bonded to a different carbon atom on the benzene ring. Among the epoxy resins represented by formula (1-X1), one wherein R^{Xg1} and R^{Xg2} are hydrogen atoms is preferable.

More preferable examples of the epoxy resin represented by formula (1-X1) include:
an epoxy resin represented by formula (1-X1a): 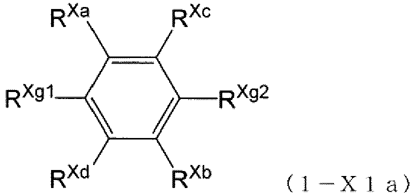 wherein in formula (1-X1a), R^{Xa}, R^{Xb}, R^{Xc}, and R^{Xd} are as defined above; and R^{Xg1} and R^{Xg2} are as defined above; and an epoxy resin represented by formula (1-X1b): 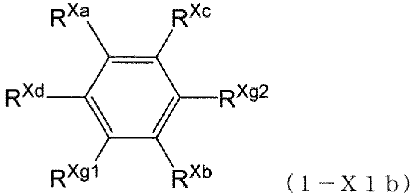 wherein in formula (1-X1b), R^{Xa}, R^{Xb}, R^{Xc}, and R^{Xd} are as defined above; and R^{Xg1} and R^{Xg2} are as defined above.

More preferable among the epoxy resins represented by formula (1-Xla) are, for example, those wherein R^{Xa} and R^{Xb} are hydrogen atoms, R^{Xc} and R^{Xd} are groups of formula (3), and R^{Xg1} and R^{Xg2} are hydrogen atoms; and those wherein R^{Xa} and R^{Xc} are hydrogen atoms, R^{Xb} and R^{Xd} are groups of formula (3), and R^{Xg1} and R^{Xg2} are hydrogen atoms.

More preferable among the epoxy resins represented by formula (1-Xlb) are, for example, those wherein R^{Xa} is a hydrogen atom, R^{Xb}, R^{Xc}, and R^{Xd} are groups of formula (3), and R^{Xg1} and R^{Xg2} are hydrogen atoms.

Moreover, when the tetravalent group represented by the above formula (1') is a group represented by the following formula: 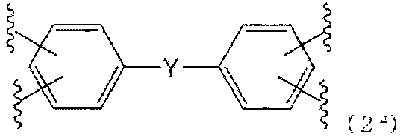 wherein in formula (2^{g}), Y is as defined above;
preferable examples of the epoxy resin represented by formula (1) also include an epoxy resin represented by formula (1-X2): 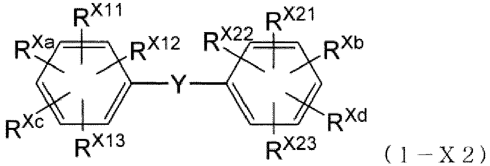 wherein in formula (1-X2), Y is as defined above; R^{Xa}, R^{Xb}, R^{Xc}, and R^{Xd} are as defined above; and R^{X11}, R^{X12}, and R^{X13}, as well as R^{X21}, R^{X22}, and R^{X23} are the same or different, and each is a hydrogen atom, a lower alkyl group, a lower alkoxy group, or a lower alkenyl group.

In formula (1-X2), R^{Xa}, R^{Xc}, R^{X11}, R^{X12}, and R^{x13} preferably each bind to a different carbon atom; and R^{Xb}, R^{Xd}, R^{X21}, R^{X22}, and R^{X23} more preferably each bind to a different carbon atom. None of R^{Xa}, R^{Xb}, R^{Xc}, R^{Xd}, R^{X11}, R^{X12}, R^{X13}, R^{X21}, R^{X22}, and R^{X23} binds to a carbon atom bonded to Y.

More preferable among the epoxy resins represented by formula (1-X2) are:
an epoxy resin represented by formula (1-X2a): 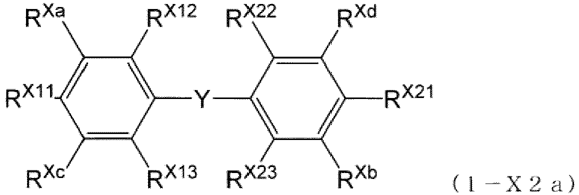 wherein in formula (1-X2a), Y is as defined above; R^{Xa}, R^{Xb}, R^{Xc}, and R^{Xd} are as defined above; and R^{X11}, R^{X12}, and R^{X13}, as well as R^{X21}, R^{X22}, and R^{X23} are the same or different, and each is a hydrogen atom, a lower alkyl group, a lower alkoxy group, or a lower alkenyl group;
an epoxy resin represented by formula (1-X2b): 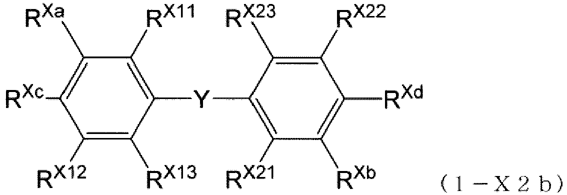 wherein in formula (1-X2b), Y is as defined above; R^{Xa}, R^{Xb}, R^{Xc}, and R^{Xd} are as defined above; and R^{X11}, R^{X12}, and R^{X13}, as well as R^{X21}, R^{X22}, and R^{X23} are the same or different, and each is a hydrogen atom, a lower alkyl group, a lower alkoxy group, or a lower alkenyl group; and
an epoxy resin represented by formula (1-X2c): 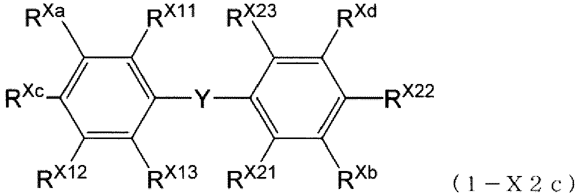 wherein in formula (1-X2c), Y is as defined above; R^{Xa}, R^{Xb}, R^{Xc}, and R^{Xd} are as defined above; and R^{X11}, R^{X12}, and R^{X13}, as well as R^{X21}, R^{X22}, and R^{X23} are the same or different, and each is a hydrogen atom, a lower alkyl group, a lower alkoxy group, or a lower alkenyl group.

More preferable among the epoxy resins represented by formula (1-X2a) are, for example, those wherein R^{Xa}, R^{Xb}, R^{Xc}, and R^{Xd} are groups of formula (3); R^{X11} and R^{X21} are lower carbon substituents; and R^{X12}, R^{X13}, R^{X22}, and R^{X23} are hydrogen atoms. Particularly preferable are those wherein Y is a C₁₋₆ alkylene group that may be substituted with a C₁₋₄ alkyl group (particularly -C(CH₃)₂-); R^{Xa}, R^{Xb}, R^{Xc}, and R^{Xd} are groups of formula (3); R^{X11} and R^{X21} are lower alkoxy groups; and R^{X12}, R^{X13}, R^{X22}, and R^{X23} are hydrogen atoms. In these cases, it is more preferable that all of the groups of formula (3) as R^{Xa}, R^{Xb}, R^{Xc}, and R^{Xd} be the same, and that the lower carbon substituents as R^{X11} and R^{X21} be the same.

Preferable among the epoxy resins represented by formula (1-X2b) are, for example, those wherein R^{Xa} and R^{Xb} are hydrogen atoms; R^{Xc} and R^{Xd} are groups of formula (3); and R^{X11}, R^{X12}, R^{X13}, R^{X21}, R^{X22}, and R^{X23} are hydrogen atoms. In this case, it is more preferable that the groups of formula (3) as R^{Xc} and R^{Xd} be the same.

Preferable among the epoxy resins represented by formula (1-X2c) are, for example, those wherein R^{Xa} is a hydrogen atom; R^{Xb}, R^{Xc}, and R^{Xd} are groups of formula (3); and R^{X11}, R^{X12}, R^{X13}, R^{X21}, R^{X22}, and R^{X23} are hydrogen atoms. In this case, it is more preferable that the groups of formula (3) as R^{Xb}, R^{Xc}, and R^{Xd} be the same.

In the present specification, the explanations relating to the X ring, R^{Xa}, R^{Xb}, R^{Xc}, and R^{Xd} in formula (1), and R¹, R², R³, m, and n in the group of formula (3), including the explanation about the group of formula (4), can be combined in any way. Any epoxy resins represented by combinations thereof can also be used in the present invention.

Formula (1) can satisfy any of the following:
(iia) one or more hydrogen atoms bonded to one or more R^{Xa-d} non-binding carbon atoms are not replaced; R^{Xa} and R^{Xb} of R^{Xa}, R^{Xb}, R^{Xc}, and R^{Xd} are hydrogen atoms; and R^{Xc} and R^{Xd} are groups of formula (3);
(iiia) one or more hydrogen atoms bonded to one or more R^{Xa-d} non-binding carbon atoms are not replaced; R^{Xa} of R^{Xa}, R^{Xb}, R^{Xc}, and R^{Xd} is a hydrogen atom; and R^{Xb}, R^{Xc}, and R^{Xd} are groups of formula (3); or
(iva) one or more hydrogen atoms bonded to one or more R^{Xa-d} non-binding carbon atoms are not replaced; and all of R^{Xa}, R^{Xb}, R^{Xc}, and R^{Xd} are groups of formula (3) .

In the case of (iia), preferable examples of the epoxy resin represented by formula (1) include an epoxy resin represented by the following formula (1-iia): 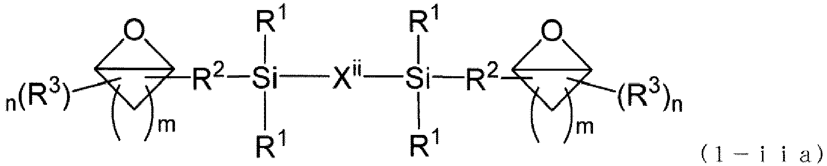 wherein Xⁱⁱ is a divalent group obtained by removing two hydrogen atoms from a hydrocarbon ring, or a divalent group represented by formula (2^{g}-iia): 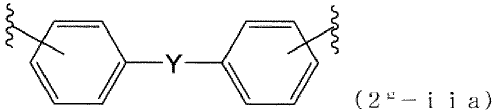 wherein Y is as defined above; and
R¹, R², R³, m, and n are as defined above.
R¹, R², R³, m, and n each may be the same or different, and are preferably the same.

The divalent group represented by Xⁱⁱ is preferably a cyclohexane-1,4-diyl group or a 1,4-phenylene group; and more preferably a 1,4-phenylene group.

Preferable among the divalent groups represented by formula (2^{g}-iia) is a group represented by formula (2^{g}-iia'): 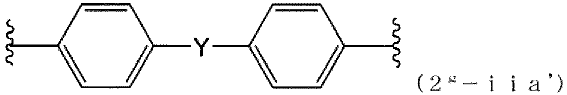 wherein Y is as defined above.

In formula (2^{g}-iia'), Y is preferably a bond, a dimethylmethylene group, an oxygen atom, or -SO₂-.

Xⁱⁱ is preferably a cyclohexane-1,4-diyl group, a 1,4-phenylene group, or a group of formula (2^{g}-iia') ; and more preferably a 1,4-phenylene group.

The present invention can more preferably use, for example, an epoxy resin represented by formula (1-iia), wherein m is the same and is 0, 1, 2, 3, or 4 (particularly preferably m is the same and is 0 or 4); n is the same and is 0 (that is, the ring is not substituted with R³) Xⁱⁱ is a divalent group obtained by removing two hydrogen atoms from a hydrocarbon ring (particularly preferably a benzene ring) ; R¹ is the same and is a C₁₋₃ alkyl group; and R² is the same and is a C₂₋₆ alkylene group, wherein one carbon atom that is not directly bonded to the silicon atom, and the 3- to 6-membered ring or epoxy ring may be replaced by an oxygen atom.

In the case of (iiia), the epoxy resins represented by formula (1) preferably include an epoxy resin represented by the following formula (1-iiia): 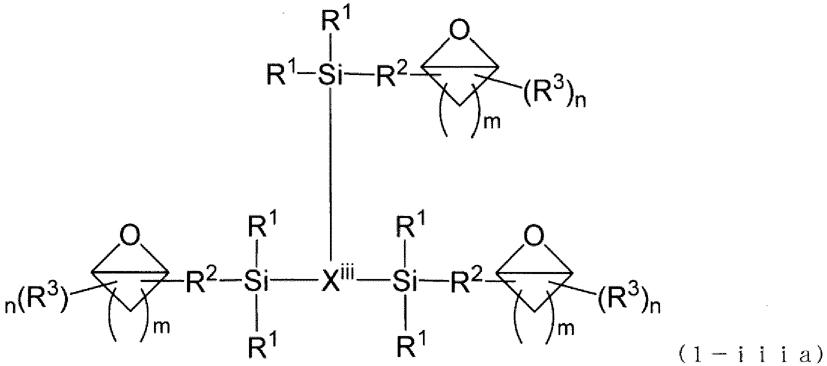 wherein Xⁱⁱⁱ is a trivalent group obtained by removing three hydrogen atoms from a hydrocarbon ring, or a trivalent group represented by formula (2^{g}-iiia) : 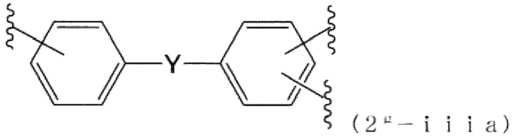 wherein Y is as defined above; and
R¹, R², R³, m, and n are as defined above.
R¹, R², R³, m, and n each may be the same or different, and are preferably the same.

Preferable examples of the trivalent group represented by Xⁱⁱⁱ include the following groups:

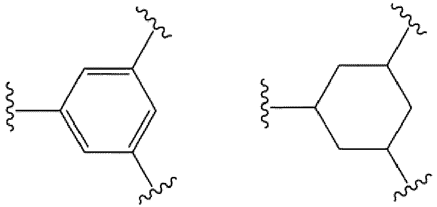

Preferable among the trivalent groups represented by formula (2^{g}-iiia) include a group represented by formula (2^{g}-iiia'): 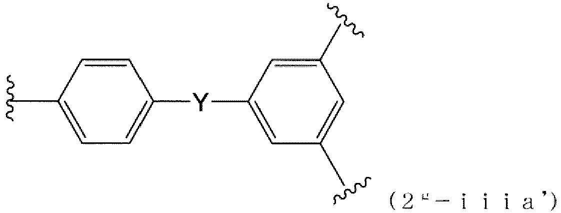 wherein Y is as defined above.

In formula (2^{g}-iiia'), Y is particularly preferably a bond, a dimethylmethylene group, an oxygen atom, or -SO₂-.

The present invention can more preferably use, for example, an epoxy resin represented by formula (1-iiia), wherein m is the same and is 0, 1, 2, 3, or 4 (particularly preferably m is the same and is 0 or 4); n is the same and is 0 (that is, the ring is not substituted with R³); Xⁱⁱⁱ is a trivalent group obtained by removing three hydrogen atoms from a hydrocarbon ring (particularly preferably a benzene ring) ; R¹ is the same and is a C₁₋₃ alkyl group; and R² is the same and is a C₂₋₆ alkylene group, wherein one carbon atom that is not directly bonded to the silicon atom and the 3- to 6-membered ring or epoxy ring may be replaced by an oxygen atom.

In the case of (iva), the epoxy resins represented by formula (1) include an epoxy resin represented by the following formula (1-iva): 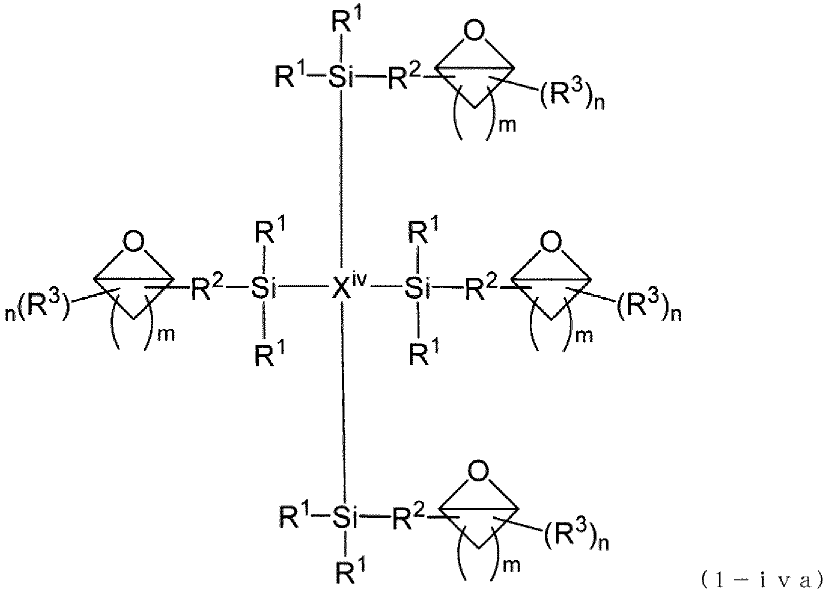 wherein X^{iv} is a tetravalent group represented by the above formula (1'), wherein one or more hydrogen atoms bonded to one or more R^{Xa-d} non-binding carbon atoms in the X ring are not replaced; and R¹, R², R³, m, and n are as defined above.
R¹, R², R³, m, and n each may be the same or different, and are preferably the same.

Preferable examples of the tetravalent group represented by X^{iv} include the following groups:

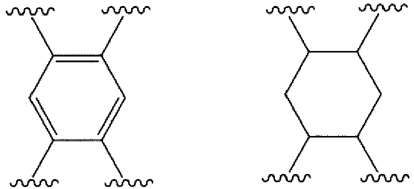

As the tetravalent group represented by X^{iv}, among tetravalent groups represented by formula (2^{g}), wherein one or more hydrogen atoms bonded to one or more R^{Xa-d} non-binding carbon atoms are not replaced, preferable is a group represented by formula (2^{g}-iva'): 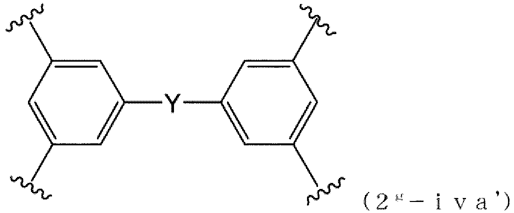 wherein Y is as defined above.

In formula (2^{g}-iva'), Y is particularly preferably a bond, a dimethylmethylene group, an oxygen atom, or -SO₂-.

The present invention can more preferably use, for example, an epoxy resin represented by formula (1-iva), wherein m is the same and is 0, 1, 2, 3, or 4 (particularly preferably m is the same and is 0 or 4); n is the same and is 0 (that is, the ring is not substituted with R³); X^{iv} is a tetravalent group obtained by removing four hydrogen atoms from a hydrocarbon ring (particularly preferably a benzene ring) ; R¹ is the same and is a C₁₋₃ alkyl group; and R² is the same and is a C₂₋₆ alkylene group, wherein one carbon atom that is not directly bonded to the silicon atom and the 3- to 6-membered ring or epoxy ring may be replaced by an oxygen atom.

More preferable among the epoxy resins represented by formula (1) are specifically, for example, compounds represented by formula (1-IIa): 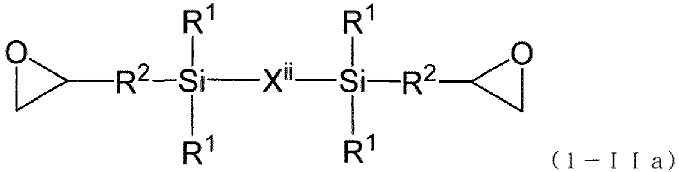 wherein R¹, R², and Xⁱⁱ are as defined above.

Preferable among the compounds represented by formula (1-IIa) are compounds wherein Xⁱⁱ is a 1,4-phenylene group or a group represented by formula (2^{g}-iia') (preferably a 1,4-phenylene group); R¹ is the same or different (preferably the same), and is a C₁₋₃ alkyl group (particularly a methyl group); and R² is the same or different (preferably the same), and is a C₂₋₆ alkylene group, (*)-(CH₂)₂-O-CH₂-, (*)-(CH₂)₃-O-CH₂-, (*)-(CH₂)₃-O-(CH₂)₂-, or (*)-(CH₂)₅-O-(CH₂)₄-. (*) represents the side of R² binding to the silicon atom, as described above.

More preferable among the epoxy resins represented by the above formula (1-IIa) is:
an epoxy resin represented by formula (1-IIa1): 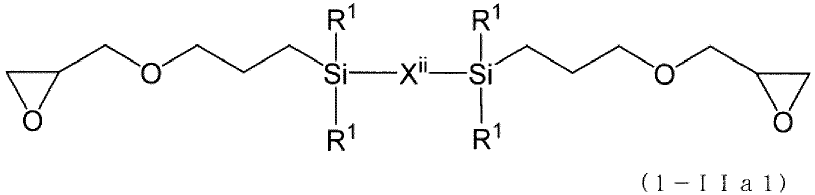 wherein R¹ and Xⁱⁱ are as defined above; or
an epoxy resin represented by formula (1-IIa2): 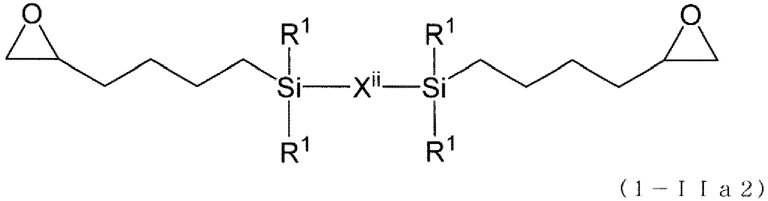 wherein R¹ and Xⁱⁱ are as defined above.
R¹ may be the same or different, and is preferably the same.

More preferably, in formula (1-IIa1) or (1-IIa2), R¹ is the same or different (preferably the same), and is a C₁₋₃ alkyl group (particularly a methyl group); and Xⁱⁱ is a 1,4-phenylene group or a group represented by formula (2^{g}-iia').

More preferable among the epoxy resins represented by formula (1) include an epoxy resin represented by formula (1-IIb) : 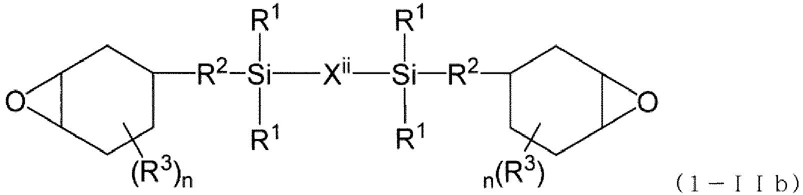 wherein R¹, R², R³, Xⁱⁱ, and n are as defined above.
R¹, R², R³, and n each may be the same or different, and are preferably the same.

More preferably, in formula (1-IIb), Xⁱⁱ is a 1,4-phenylene group or a group represented by formula (2^{g}-iia') (preferably a 1,4-phenylene group); R¹ is the same or different (preferably the same), and is a C₁₋₃ alkyl group (particularly a methyl group); both n is 0 (that is, the ring is not substituted with R³); and R² is the same or different (preferably the same), and is a C₂₋₆ alkylene group (preferably a dimethylene group: - (CH₂)₂-).

More preferable among the epoxy resins represented by formula (1) is an epoxy resin represented by formula (1-IIIa): 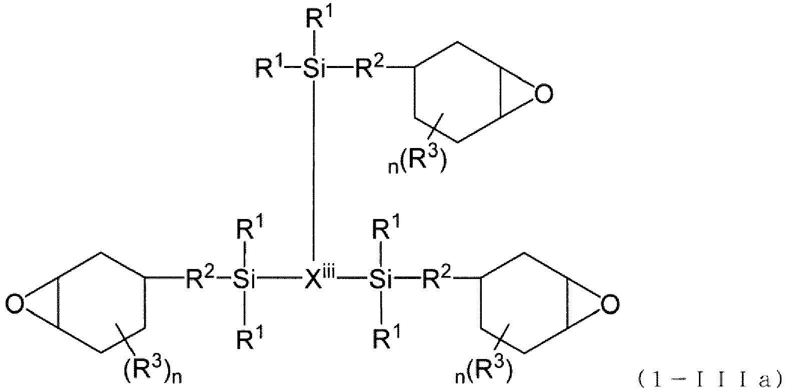 wherein R¹, R², R³, Xⁱⁱⁱ, and n are as defined above.
R¹, R², R³, and n each may be the same or different, and are preferably the same.

More preferably, in formula (1-IIIa), Xⁱⁱⁱ is 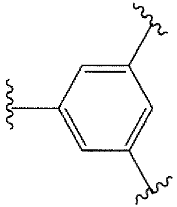 or 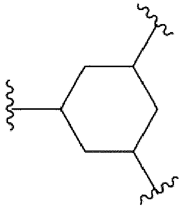 or a group represented by formula (2^{g}-iiia'); R¹ is the same or different (preferably the same), and is a C₁₋₃ alkyl group (particularly a methyl group); both n is 0 (that is, the ring is not substituted with R³); and R² is the same or different (preferably the same), and is a C₂₋₆ alkylene group (preferably a dimethylene group: -(CH₂)₂-).

In the epoxy resin composition of the present invention, the epoxy resins represented by formula (1) can be used singly or in combination of two or more.

The epoxy resin represented by formula (1) can be produced by or according to a known method, for example, based on or according to the disclosure of patent literature (GB1123960B). Moreover, the epoxy resin represented by formula (1-iia) can be produced by, for example, a reaction represented by the following reaction formula: 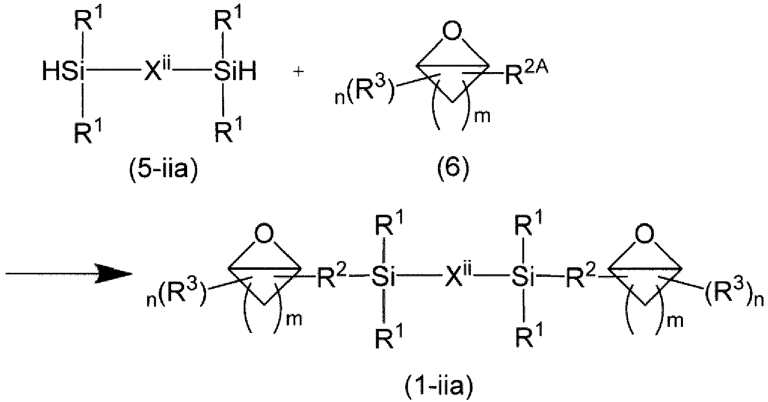 wherein R^{2A} is a C₂₋₁₈ alkenyl group, wherein one or more carbon atoms of this group may be replaced by at least one atom selected from the group consisting of an oxygen atom and a nitrogen atom; and R¹, R², R³, and Xⁱⁱ are as defined above.

The C₂₋₁₈ alkenyl group represented by R^{2A} is a linear or branched alkenyl group, and preferably a linear alkenyl group. Specific examples include a vinyl group, an allyl group, a propenyl group, a butenyl group, a pentenyl group, a hexenyl group, a heptenyl group, an octenyl group, a norbornenyl group, a cyclohexenyl group, and the like. A C₂₋₁₀ alkenyl group is preferable; a C₂₋₈ alkenyl group is more preferable; a C₂₋₆ alkenyl group is even more preferable; and a vinyl group, an allyl group, or a butenyl group is particularly preferable. The alkenyl group is preferably an α-alkenyl group.

One or more carbon atoms of these C₂₋₁₈ alkylene groups may be replaced by at least one atom selected from the group consisting of an oxygen atom and a nitrogen atom (preferably an oxygen atom). The one or more carbon atoms are preferably carbon atoms that are not directly bonded to the epoxy ring. Moreover, the one or more carbon atoms that may be replaced are one or plural (e.g., 2, 3, 4, 5, or 6) carbon atoms, and preferably one carbon atom. Examples of this group include C₂₋₉ alkenyl-O-C₁₋₈ alkylene-, preferably C₂₋₄ alkenyl-O-C₁₋₃ alkylene-, more preferably C₂₋₄ alkenyl-O-C₁₋₂ alkylene-, and particularly preferably C₃ alkenyl-O-CH₂-. Specific examples include CH₂ = CHO-CH₂-, CH₂ = CH-CH₂-O-CH₂-, CH₂ = CH-CH₂-O- (CH₂)₂-, CH₂ = CH-(CH₂)₃-O-(CH₂)₄-, and the like; among these, CH₂ = CH-CH₂-O-CH₂-(allyloxymethyl group) is preferable.

The epoxy resin represented by formula (1-iia) can be produced by hydrosilylation of the compound represented by formula (5-iia) and the compound represented by formula (6). Hydrosilylation can be generally performed in the presence of a catalyst in the presence or absence of a solvent. Moreover, when a compound represented by formula (5-iiia): 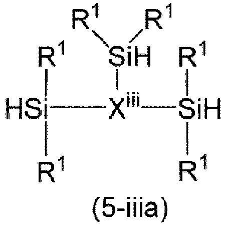 wherein R¹ and Xⁱⁱⁱ are as defined above; or
formula (5-iva): 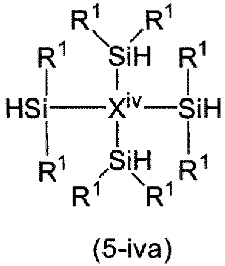 wherein R¹ and X^{iv} are as defined above;
is used in place of the compound represented by formula (5-iia), an epoxy resin represented by the above formula (1-iiia) or (1-iva), or an epoxy resin having a structure in which one group of formula (3) is bonded to a hydrocarbon ring can also be produced. Moreover, various compounds represented by formula (1) can be produced by using compounds having a structure in which Xⁱⁱ to X^{iv} are each replaced by a divalent group obtained by removing two hydrogen atoms from the X ring, a trivalent group obtained by removing three hydrogen atoms from the X ring, or a tetravalent group obtained by removing four hydrogen atoms from the X ring.

The catalyst used in hydrosilylation may be a known catalyst. Examples include platinum-based catalysts, such as platinum carbon, chloroplatinic acid, olefin complexes of platinum, alkenylsiloxane complexes of platinum, and carbonyl complexes of platinum; rhodium-based catalysts, such as tris(triphenylphosphine)rhodium; and iridium-based catalysts, such as bis(cyclooctadienyl)dichloroiridium. These catalysts may be in the form of solvates (e.g., hydrates, alcoholates, etc.). Further, the catalyst may be used in the form of a solution obtained by dissolving the catalyst in an alcohol (e.g., ethanol) when used. These catalysts can be used singly or in a combination of two or more.

The amount of the catalyst used may be an effective amount as the catalyst. For example, the amount of the catalyst used is 0.00001 to 20 parts by mass, and preferably 0.0005 to 5 parts by mass, based on the total amount of 100 parts by mass of the compound represented by formula (5-iia), (5-iiia), or (5-iva), and the compound represented by formula (6).

Although hydrosilylation proceeds without use of a solvent, the reaction can be carried out under milder conditions by using a solvent. Examples of solvents include aromatic hydrocarbon solvents, such as toluene and xylene; aliphatic hydrocarbon solvents, such as hexane and octane; ether solvents, such as tetrahydrofuran and dioxane; alcohol solvents, such as ethanol and isopropanol; and the like. These may be used singly or in a combination of two or more.

The amount of the compound represented by formula (6) used is, for example, generally 0.5 to 2 mol, preferably 0.6 to 1.5 mol, and more preferably 0.8 to 1.2 mol, per mol of the Si-H group in the compound represented by formula (5-iia), (5-iiia), or (5-iva).

The reaction temperature is generally 0°C to 150°C, and preferably 10°C to 120°C. The reaction time is generally about 1 hour to 24 hours.

After completion of the reaction, the solvent is distilled off from the reaction mixture, or a known isolation method is used, thereby obtaining an epoxy resin represented by formula (1).

The epoxy resin contained in the resin composition of the present disclosure is an epoxy resin the cured product of which alone has a dielectric loss tangent of 0.03 or less at a frequency of 10 GHz at 25°C. The dielectric loss tangent is preferably 0.028 or less, 0.026 or less, 0.024 or less, 0.022 or less, or 0.02 or less, and more preferably 0.018 or less, 0.016 or less, 0.014 or less, 0.012 or less, or 0.01 or less. Further, the epoxy resin is an epoxy resin the cured product of which alone preferably has a relative dielectric constant of 3.0 or less, more preferably 2.9 or less or 2.8 or less, and even more preferably 2.7 or less, 2.6 or less, or 2.5 or less at a frequency of 10 GHz at 25°C. In the present specification, the cured product of an epoxy resin alone refers to the cured product of an epoxy resin composition comprising 100 parts by mass of an epoxy resin and 1.0 to 2.0 parts by mass of a curing accelerator. The cured product of an epoxy resin alone may be simply referred to as the cured product of an epoxy resin. The relative dielectric constant and the dielectric loss tangent are measured by a cavity resonator perturbation method. For example, the relative dielectric constant and the dielectric loss tangent can be measured using a dielectric constant measurement device (a network analyzer).

The epoxy equivalent of the epoxy resin is, for example, preferably about 50 to 3000, more preferably about 80 to 2000, and even more preferably about 100 to 1000, or about 100 to 500. The epoxy equivalent is measured according to JIS K7236. More specifically, the epoxy equivalent is calculated by dissolving a weighed epoxy resin in chloroform, adding acetic acid and a tetraethylammonium bromide-acetic acid solution, adding a 0.1 mol/L perchloric acid-acetic acid standard solution dropwise using a potentiometric titration device (Hiranuma Automatic Titrator COM-1700A, produced by Hiranuma Co., Ltd.), and detecting the end point at which all epoxy groups have reacted. The epoxy equivalent is the mass of a resin containing one equivalent of epoxy groups.

Although there is no particular limitation, the resin composition can contain the epoxy resin in an amount of, for example, about 0.2 to 15 mass%, and preferably about 0.5 to 10 mass%, about 1.0 to 10 mass%, about 1.2 to 8 mass%, or about 1.5 to 5 mass%. Moreover, although there is no particular limitation, the equivalent amount of epoxy groups of the epoxy resin is preferably 0.3 to 4.0, more preferably 0.4 to 3.5, and even more preferably 0.5 to 3.0, per equivalent of acid-modified groups (preferably, carboxyl groups) of the acid-modified polyolefin contained in the resin composition.

The content of the epoxy resin in the resin composition is not particularly limited, and is, for example, preferably 1 to 10 parts by mass, more preferably 1.5 to 9.0 parts by mass, and even more preferably 2.0 to 8.0 parts by mass, per 100 parts by mass of the acid-modified polyolefin.

### Inorganic Filler

Examples of the inorganic filler include inorganic compounds, such as silica (specifically crystalline silica, fused silica, spherical fused silica, etc.), alumina, titanium oxide, zirconium oxide, zinc oxide, tin oxide, silicon nitride, silicon carbide, boron nitride, calcium carbonate, calcium silicate, potassium titanate, aluminum nitride, indium oxide, antimony oxide, cerium oxide, magnesium oxide, iron oxide, and tin-doped indium oxide (ITO). Of these, silica is preferable. The inorganic fillers may be used singly or in a combination of two or more.

When the inorganic filler is used in the resin composition of the present disclosure, the inorganic filler may be used in a powder form, or may be used after being dispersed in a resin.

The inorganic filler preferably has a volume average particle size of 5.0 µm or less, more preferably 3.0 µm or less, and even more preferably 1.5 µm or less. In terms of improving the dispersibility in the resin composition, the lower limit of the volume average particle size is preferably 0.05 µm or more, more preferably 0.06 µm or more, and even more preferably 0.07 µm or more.

The content of the inorganic filler is, for example, preferably 1 to 100 parts by mass, more preferably 20 to 80 parts by mass, and even more preferably 30 to 70 parts by mass or 40 to 60 parts by mass, per 100 parts by mass of the acid-modified polyolefin.

Although there is no particular limitation, the inorganic filler preferably has a relative dielectric constant of 5.0 or less, more preferably 4.5 or less, and even more preferably 4.0 or less at a frequency of 1 MHz at 25°C. The inorganic filler preferably has a dielectric loss tangent of 0.005 or less, more preferably 0.003 or less, and even more preferably 0.001 or less at a frequency of 1 MHz at 25°C.

### Resin Composition

The resin composition of the present invention may contain, for example, curing agents, curing accelerators, thermoplastic resins other than acid-modified polyolefins, additives, etc., if necessary, within a range that does not impair the effects.

The curing agent is not particularly limited as long as it has a function of curing the epoxy resin (i.e., an epoxy resin curing agent). Examples include amine-based curing agents, amide-based curing agents, acid anhydride-based curing agents, phenol-based curing agents, benzoxazine-based curing agents, naphthol-based curing agents, mercaptan-based curing agents, isocyanate-based curing agents, active ester-based curing agents, cyanate ester-based curing agents, carbodiimide-based curing agents, and the like. Acid anhydride-based curing agents, phenol-based curing agents, benzoxazine-based curing agents, naphthol-based curing agents, active ester-based curing agents, and cyanate ester-based curing agents are preferable, and acid anhydride-based curing agents, benzoxazine-based curing agents, and active ester-based curing agents are more preferable. The curing agents may be used singly or in a combination of two or more.

The mixing ratio of the curing agent in the resin composition of the present invention is not particularly limited within the range in which the effects of the resin composition of the present disclosure can be exhibited. For example, the ratio of the equivalent of reactive functional groups in the curing agent to the equivalent of epoxy groups in the epoxy resin is preferably 10:90 to 90:10, more preferably 20:80 to 80:20, even more preferably 30:70 to 70:30, and still even more preferably 40:60 to 60:40.

In the resin composition of the present disclosure, the total mass of the epoxy resin and the curing agent is preferably 9 parts by mass or less, and more preferably 8.5 parts by mass or less, 8 parts by mass or less, 7.5 parts by mass or less, 7 parts by mass or less, 6.5 parts by mass or less, or 6 parts by mass or less, based on 100 parts by mass of the total mass of the acid-modified polyolefin, the epoxy resin, and the curing agent (epoxy resin curing agent) (as described above, the curing agent may or may not be contained in the resin composition; thus, in the calculation of the total mass, when the curing agent is not contained, the mass of the curing agent contained is calculated as 0).

Examples of curing accelerators include imidazoles, such as 2-methylimidazole, 2-ethylimidazole, 2-phenylimidazole, 2-ethyl-4-methylimidazole, 1,2-dimethylimidazole, 1-(2-cyanoethyl)-2-ethyl-4-methylimidazole, 2-undecylimidazole, and 2-phenylimidazoline; tertiary amines, such as 2-(dimethylaminomethyl)phenol, triethylenediamine, triethanolamine, 4-dimethylaminopyridine, 1,8-diazabicyclo(5,4,0)undecene-7, 1,5-diazabicyclo(4,3,0)-nonen-5, 1,8-bis(dimethylamino)naphthalene, 1,1,3,3-tetramethylguanidine, 7-methyl-1,5,7-triazabicyclo[4.4.0]dec-5-ene, and 1,5,7-triazabicyclo[4.4.0]dec-5-ene; organic phosphines, such as triphenylphosphine, diphenylphosphine, and tributylphosphine; metal compounds, such as tin octylate; phosphonium salts, such as ethyltriphenylphosphonium bromide and tetraphenylphosphonium tetraphenylborate; and the like. In terms of increasing the curability of the resin composition, 2-ethyl-4-methylimidazole, 1,2-dimethylimidazole, 4-dimethylaminopyridine, and triphenylphosphine are preferable.

The amount of the curing accelerator used is not particularly limited, and is preferably 0.01 to 10.0 parts by mass, and more preferably 0.1 to 5 parts by mass or 0.1 to 2 parts by mass, per 100 parts by mass of the epoxy resin in the resin layer.

Examples of thermoplastic resins other than acid-modified polyolefins include polyolefin resins, acrylic resins, phenoxy resins, polyamide resins, polyester resins, polycarbonate resins, polyurethane resins, polyarylate resins, polyphenylene ether resins, polyacetal resins, acid-modified products thereof, and the like. In terms of compatibility with the epoxy resin composition of the present invention and heat resistance, examples of thermoplastic resins other than acid-modified polyolefins include polyolefin resins, acrylic resins, phenoxy resins, polyarylate resins, polyphenylene ether resins, and the like.

Examples of additives include coupling agents, antioxidants, inorganic fluorescent substances, lubricants, ultraviolet absorbers, heat light stabilizers, antistatic agents, polymerization inhibitors, antifoaming agents, solvents, anti-aging agents, radical inhibitors, adhesion-improving agents, flame retardants, surfactants, storage stability-improving agents, ozone aging inhibitors, thickeners, plasticizers, radiation-blocking agents, nucleating agents, conductivityimparting agents, phosphorus-based peroxide-decomposing agents, pigments, metal deactivators, physical property-controlling agents, and the like.

The cured product of the resin composition of the present disclosure exhibits excellent dielectric loss tangent. The cured product preferably exhibits a dielectric loss tangent of 0.003 or less at a frequency of 10 GHz at 25°C. In some embodiments, the dielectric loss tangent can be more preferably 0.0029 or less or 0.0028 or less, even more preferably 0.0027 or less, 0.0026 or less, or 0.0025 or less, and still even more preferably 0.0024 or less, 0.0023 or less, 0.0022 or less, 0.0021 or less, or 0.0020 or less. Furthermore, the cured product of the resin composition of the present disclosure exhibits an excellent dielectric loss tangent even under high temperature and high humidity (in particular, after storage under high temperature and high humidity). The cured product exhibits a dielectric loss tangent of 0.003 or less at a frequency of 10 GHz at 25°C after a high-temperature, high-humidity test (treatment for 168 hours under conditions of 85°C and 85% RH). In some embodiments, the dielectric loss tangent can be preferably 0.0029 or less or 0.0028 or less, more preferably 0.0027 or less, 0.0026 or less, or 0.0025 or less, and even more preferably 0.0024 or less, 0.0023 or less, 0.0022 or less, 0.0021 or less, or 0.0020 or less.

The dielectric loss tangent of the cured product is measured by a cavity resonator perturbation method, using a resin film (composed of the cured product of the resin composition) having a thickness of 100 µm. For example, a network analyzer can be used as the measurement device.

The cured product of the resin composition of the present disclosure can exhibit such an excellent dielectric loss tangent largely because the cured product of the epoxy resin alone contained in the resin composition (the cured product of the epoxy resin) has a dielectric loss tangent of 0.03 or less at a frequency of 10 GHz at 25°C, and because the total mass of the epoxy resin and the curing agent is about 9 parts by mass or less, based on 100 parts by mass of the total mass of the acid-modified polyolefin, the epoxy resin, and the curing agent (the epoxy resin curing agent), in the resin composition. In other words, the resin composition of the present disclosure can be preferably obtained by preparing a resin composition using an epoxy resin the cured product of which alone (the cured product of the epoxy resin) has a dielectric loss tangent of 0.03 or less at a frequency of 10 GHz at 25°C as an epoxy resin contained in the resin composition so that the total mass of the epoxy resin and the curing agent is about 9 parts by mass or less based on 100 parts by mass of the total mass of the acid-modified polyolefin, the epoxy resin, and the curing agent (the epoxy resin curing agent), in the resin composition; and then confirming whether the above dielectric loss tangent value is exhibited, if necessary.

Moreover, the resin composition of the present disclosure can be used, for example, as an adhesive. More specifically, the resin composition of the present disclosure can be used, for example, as an adhesive for various components of flexible printed circuit boards (FPCs). The resin composition can be formed into an adhesive film or the like, and the film can be used as an adhesive film. The present disclosure also preferably includes such an adhesive film and various components. The adhesive film and various components are also described below.

### Adhesive Film

The adhesive film of this embodiment comprises the resin composition of the present disclosure. The adhesive film can be prepared, for example, by applying the resin composition of the present disclosure to a release film. More specifically, the adhesive film can be obtained by applying the resin composition of the present disclosure to the release-treated surface of, for example, a polyethylene terephthalate (PET) film, a polypropylene (PP) film, or a polyethylene (PE) film that has been subjected to release treatment on at least one side thereof, followed by drying under appropriate conditions (for example, temperature: 80 to 180°C; time: 2 to 10 minutes) until it reaches a semi-cured state (B-stage). Examples of the coating method include, but are not particularly limited to, methods using a comma coater, a die coater, a gravure coater, and the like. The adhesive film in a fully cured state (C-stage) can be obtained by treating the adhesive film in B-stage under appropriate curing conditions (for example, temperature: 160 to 180°C; pressure: 2 to 3 MPa; time: 30 to 120 minutes).

The thickness of the adhesive film after curing is not particularly limited, and is preferably 2 to 200 µm, more preferably 5 to 150 µm, and even more preferably 10 to 100 µm.

### Coverlay Film

The present disclosure also includes a coverlay film having a structure in which an adhesive layer containing the resin composition of the present disclosure and an electrical insulating layer are laminated.

When the coverlay film is used as an FPC component, the electrical insulating layer has a role in protecting a circuit or the like formed on a circuit board. The material that forms the electrical insulating layer is not particularly limited, and is, for example, at least one resin selected from the group consisting of polyimide, liquid crystalline polymer, polyphenylene sulfide, syndiotactic polystyrene, polyethylene terephthalate, polyethylene naphthalate, polycarbonate, polybutylene terephthalate, polyether ether ketone, and fluorine-based resin.

The fluorine-based resin as the electrical insulating layer is not particularly limited, and is, for example, at least one member selected from the group consisting of polytetrafluoroethylene, polytetrafluoroethylene-perfluoroalkyl vinyl ether copolymers, tetrafluoroethylene-hexafluoropropylene copolymers, difluoroethylene-trifluoroethylene copolymers, tetrafluoroethylene-ethylene copolymers, polychlorotrifluoroethylene, and polyvinylidene fluoride.

### Laminated Sheet

The present disclosure also includes a laminated sheet having a laminated structure in which an adhesive layer containing the resin composition of the present disclosure, an electrical insulating layer, and copper foil are laminated. In the laminated sheet, it is preferred that the adhesive layer has a first surface and a second surface opposite to the first surface, that the electrical insulating layer is laminated on the first surface of the adhesive layer, and that the copper foil is laminated on the second surface of the adhesive layer. Since the laminated sheet contains the resin composition of the present disclosure in the adhesive layer, the laminated sheet is excellent in, for example, dielectric characteristics under high humidity, UV laser processability, and adhesion.

The laminated sheet may be a double-sided copper-clad laminated sheet having a structure that comprises an adhesive layer containing the resin composition of the present disclosure, an electrical insulating layer, and copper foil, wherein the adhesive layer is laminated on both surfaces of the electrical insulating layer, and the copper foil is laminated on the surface of each adhesive layer opposite to the surface of the adhesive layer on which the electrical insulating layer is laminated. The double-sided copper-clad laminated sheet has a structure in which an adhesive layer and copper foil are further provided on the surface of the electrical insulating layer of the single-sided copper-clad laminated sheet opposite to the surface of the electrical insulating layer on which the adhesive layer and copper foil are laminated.

It is preferred that the cured state of the adhesive layer of the laminated sheet is different from that of the coverlay film. Specifically, the cured state of the adhesive layer in the coverlay film is preferably B-stage, whereas the cured state of the adhesive layer in the laminated sheet is preferably C-stage.

The thickness of the adhesive layer in the laminated sheet is preferably 2 to 200 µm, more preferably 5 to 100 µm, and even more preferably 5 to 50 µm. When the thickness of the adhesive layer is 2 µm or more, the adhesion between the electrical insulating layer and an adherend tends to be good. When the thickness of the adhesive layer is 200 µm or less, the bendability tends to be good.

In the components described above, a separate film may be further laminated on the surface where the adhesive layer is exposed. As the separate film, one formed from an appropriate resin can be preferably used. The resin is not particularly limited, and is, for example, at least one resin selected from the group consisting of polyethylene terephthalate resins, polyethylene naphthalate resins, polypropylene resins, polyethylene resins, and polybutylene terephthalate resins. Of these, at least one resin selected from the group consisting of polypropylene resins, polyethylene resins, and polyethylene terephthalate resins is preferable in terms of reducing manufacturing costs. Components having a separate film are preferably used after the separate film is peeled off. For example, such components can be used so that the adhesive layer surface is attached to an adherend after the separate film is peeled off.

### Flexible Printed Circuit Board

The present disclosure also includes a flexible printed circuit board comprising the resin composition of the present disclosure. For example, the present disclosure also includes a flexible printed circuit board comprising the coverlay film and the laminated sheet, the flexible printed circuit board being obtained by forming a circuit on the copper foil of the laminated sheet and then adhering the adhesive layer of the coverlay film to the circuit formation surface of the laminated sheet.

### Production Method

The methods for producing the components are not particularly limited, and known methods can be used. For example, the coverlay film can be preferably produced by a method comprising the following step (I):
(I) applying a varnish of a resin composition for forming an adhesive layer to one side of an electrical insulating layer and drying the varnish to B-stage.

The single-sided copper-clad laminated sheet can be produced, for example, by further performing the following step (II) in addition to step (I) above:
(II) heat pressing copper foil onto the adhesive layer surface of the coverlay film obtained in step (I) and drying the adhesive layer to C-stage.

The double-sided copper-clad laminated sheet can be produced, for example, by laminating an adhesive layer and copper foil on the other side of the electrical insulating layer of the single-sided copper-clad laminated sheet in the same manner as above.

Examples of solvents that can be used in the varnish include acetone, toluene, methyl ethyl ketone, methyl isobutyl ketone, cyclohexanone, propylene glycol monomethyl ether, dimethylacetamide, butyl acetate, ethyl acetate, and the like.

As a method for applying the varnish, a comma coater, a die coater, a gravure coater, etc. can be appropriately employed according to the coating thickness. The varnish can be dried by, for example, an in-line dryer, and the drying conditions can be appropriately adjusted according to, for example, the type and amount of resin and additives.

In the present specification, the term "comprising" includes "consisting essentially of" and "consisting of." Further, the present disclosure includes any combination of the constituent requirements described in the present specification.

In addition, the various characteristics (properties, structures, functions, etc.) described in each embodiment of the present disclosure described above may be combined in any way in specifying the subjects included in the present disclosure. In other words, the present disclosure includes all the subjects comprising all combinations of the combinable characteristics described in the present specification.

### Examples

The embodiments of the present disclosure are more specifically explained below with reference to Examples; however, the embodiments are not limited to the Examples shown below.

### Production Example 1 (Production of Epoxy Resin A)

Allyl glycidyl ether (5.9 g), 0.05 g of 2 mass% ethanol solution of hexachloroplatinic acid hexahydrate, and 100 g of toluene were placed in a 200-mL four-necked flask equipped with a stirrer, a thermometer, and a condenser in a nitrogen atmosphere, and the liquid temperature was raised to 70°C. Thereafter, 5.0 g of 1,4-bis(dimethylsilyl)benzene was added dropwise for 15 minutes, and the mixture was then stirred at 90°C for 4 hours. After the toluene was removed by concentration, 10.3 g (epoxy equivalent: 211 g/eq) of 1,4-bis[(2,3-epoxypropyloxypropyl)dimethylsilyl]benzene (epoxy resin A) was obtained as a colorless, transparent liquid.

### Production Example 2 (Production of Epoxy Resin B)

1,2-Epoxy-5-hexene (5.0 g), 0.05 g of 2 mass% ethanol solution of hexachloroplatinic acid hexahydrate, and 100 g of toluene were placed in a 200-mL four-necked flask equipped with a stirrer, a thermometer, and a condenser in a nitrogen atmosphere, and the liquid temperature was raised to 70°C. Thereafter, 5.0 g of 1,4-bis(dimethylsilyl)benzene was added dropwise for 15 minutes, and the mixture was then stirred at 90°C for 5 hours. After the toluene was removed by concentration, 9.5 g (epoxy equivalent: 195 g/eq) of 1,4-bis[(5,6-epoxyhexyl)dimethylsilyl]benzene (epoxy resin B) was obtained as a colorless, transparent liquid.

### Production Example 3 (Production of Epoxy Resin C)

3,4-Epoxy-1-butene (4.0 g), 0.05 g of 2 mass% ethanol solution of hexachloroplatinic acid hexahydrate, and 100 g of toluene were placed in a 200-mL four-necked flask equipped with a stirrer, a thermometer, and a condenser in a nitrogen atmosphere, and the liquid temperature was raised to 70°C. Thereafter, 5.0 g of 1,4-bis(dimethylsilyl)benzene was added dropwise for 15 minutes, and the mixture was then stirred at 90°C for 5 hours. After the toluene was removed by concentration, 8.5 g (epoxy equivalent: 167 g/eq) of 1,4-bis[(3,4-epoxybutyl)dimethylsilyl]benzene (epoxy resin C) was obtained as a colorless, transparent liquid.

### Production Example 4 (Production of Epoxy Resin D)

1,2-Epoxy-4-vinylcyclohexane (6.4 g), 0.05 g of 2 mass% ethanol solution of hexachloroplatinic acid hexahydrate, and 100 g of toluene were placed in a 200-mL four-necked flask equipped with a stirrer, a thermometer, and a condenser in a nitrogen atmosphere, and the liquid temperature was raised to 70°C. Thereafter, 5.0 g of 1,4-bis(dimethylsilyl)benzene was added dropwise for 15 minutes, and the mixture was then stirred at 90°C for 4 hours. After the toluene was removed by concentration, 10.8 g (epoxy equivalent: 221 g/eq) of 1,4-bis{[2-(3,4-epoxycyclohexyl)ethyl]dimethylsilyl}benzene (epoxy resin D) was obtained as a colorless, transparent liquid.

### Production Example 5 (Production of Epoxy Resin E)

1,2-Epoxy-4-vinylcyclohexane (4.3 g), 0.05 g of 2 mass% ethanol solution of hexachloroplatinic acid hexahydrate, and 100 g of toluene were placed in a 200-mL four-necked flask equipped with a stirrer, a thermometer, and a condenser in a nitrogen atmosphere, and the liquid temperature was raised to 70°C. Thereafter, 5.0 g of bis[(p-dimethylsilyl) phenyl]ether was added dropwise for 15 minutes, and the mixture was then stirred at 90°C for 6 hours. After the toluene was removed by concentration, 8.9 g (epoxy equivalent: 267 g/eq) of 4,4'-bis {[2-(3,4-epoxycyclohexyl)ethyl]dimethylsilyl}diphenyl ether (epoxy resin E) was obtained as a colorless, transparent liquid.

### Production Example 6 (Production of Epoxy Resin F)

1,2-Epoxy-4-vinylcyclohexane (7.4 g), 0.05 g of 2 mass% ethanol solution of hexachloroplatinic acid hexahydrate, and 100 g of toluene were placed in a 200-mL four-necked flask equipped with a stirrer, a thermometer, and a condenser in a nitrogen atmosphere, and the liquid temperature was raised to 70°C. Thereafter, 5.0 g of 1,3,5-tris(dimethylsilyl)benzene was added dropwise for 15 minutes, and the mixture was then stirred at 90°C for 6 hours. After the toluene was removed by concentration, 11.8 g (epoxy equivalent 208 g/eq) of 1,3,5-tris{[2-(3,4-epoxycyclohexyl)ethyl]dimethylsilyl}benzene (epoxy resin F) was obtained as a colorless, transparent liquid.

The raw materials used in each Example are shown below.
- Acid-modified polyolefin A: hydrogenated styrene thermoplastic elastomer, Tuftec M1913 (produced by Asahi Kasei Corporation, maleic anhydride-modified polyolefin resin (more specifically, hydrogenated SEBS (styrene-ethylene-butylene-styrene copolymer) grafted with a maleic anhydride group), acid value: about 10 mgKOH/g, about 7000 g/eq)
- Acid-modified polyolefin B: special polyolefin resin, Surflen (produced by Mitsubishi Chemical Corporation) (acid value: about 15 mg KOH/g, about 4000 g/eq)
- Epoxy resin G: bisphenol A epoxy resin (jER 828, produced by Mitsubishi Chemical Corporation) (epoxy equivalent: 175 g/eq)
- Epoxy resin H: dicyclopentadiene epoxy resin (HP-7200, produced by DIC Corporation) (epoxy equivalent: 268 g/eq)
- Epoxy resin I: biphenyl epoxy resin (NC-3000-H, produced by Nippon Kayaku Co., Ltd.) (epoxy equivalent: 286 g/eq)
- Epoxy resin J: anthracene epoxy resin (jER YX8800, produced by Mitsubishi Chemical Corporation) (epoxy equivalent: 179 g/eq)
- Epoxy resin K: alicyclic epoxy resin (Celloxide 2021P; general name: 3',4'-epoxycyclohexylmethyl 3,4-epoxycyclohexane carboxylate, produced by Daicel Corporation) (epoxy equivalent: 137 g/eq)
- Epoxy resin L: naphthalene epoxy resin (HP-4032D, produced by DIC Corporation) (epoxy equivalent: 142 g/eq)
- Curing agent A: Rikacid MH-700 (produced by New Japan Chemical Co., Ltd.)
- Curing agent B: EPICLON HPC-8000-65T(produced by DIC Corporation)
Inorganic filler A: silica, SC2050-MB (produced by Admatechs) (particle diameter: 0.5 µm)
- Curing accelerator A: SAN-AID SI-100L (produced by Sanshin Chemical Industry Co., Ltd.)
- Curing accelerator B: Curezol 2E4MZ (produced by Shikoku Chemicals Corporation)
- Curing accelerator C: Curezol 1.2DMZ (produced by Shikoku Chemicals Corporation)
- Curing accelerator D: N,N-dimethyl-4-aminopyridine (DMAP, produced by Tokyo Chemical Industry Co., Ltd.)

Table 1a shows the structural formulas of epoxy resins A to J. Table 1b shows the structural formulas of curing agents A and B and curing accelerators A to D.

**Table 1a**

| | |
|---|---|
| Epoxy resin A | 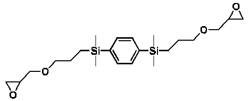 |
| Epoxy resin B | 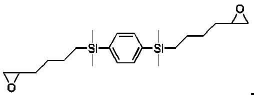 |
| Epoxy resin C | 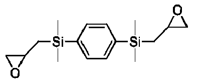 |
| Epoxy resin D | 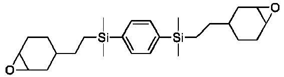 |
| Epoxy resin E | 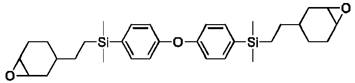 |
| Epoxy resin F | 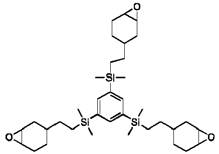 |
| Epoxy resin G | 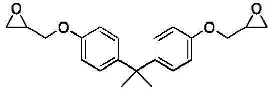 |
| Epoxy resin H | 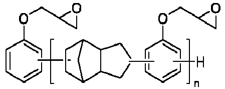 |
| Epoxy resin I | 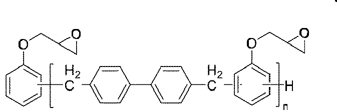 |
| Epoxy resin J | 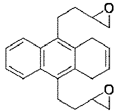 |
| Epoxy resin K | 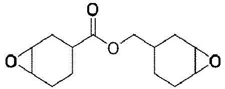 |
| Epoxy resin L | 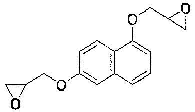 |

**Table 1b**

| | |
|---|---|
| Curing accelerator A SAN-AID SI-100L | 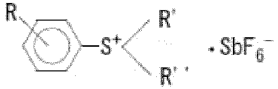 |
| Curing accelerator B Curezol 2E4MZ | 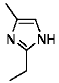 |
| Curing accelerator C Curezol 1.2DMZ | 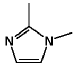 |
| Curing accelerator D DMAP | 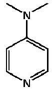 |
| Curing agent A Rikacid MH-700 | 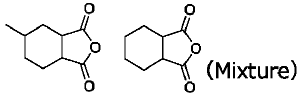 |
| Curing agent B HPC-8000-65T | 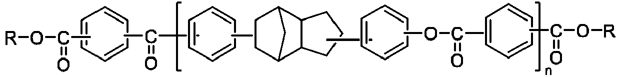 |

### Examples A to J and Comparative Examples K to L

### Measurement Of Relative Dielectric Constant and Dielectric Loss Tangent

Each component was weighed to the amount shown in Table 2 (part by mass) and mixed. The obtained epoxy resin compositions were each poured into a resin mold (thickness: 3 mm) and cured by heating in the following order: 1 hour at 60°C, 1 hour at 100°C, 2 hours at 120°C, 2 hours at 150°C, 2 hours at 180°C, and 2 hours at 200°C. The resulting cured products were then cut into pieces having a width of 3 mm, length of 80 mm, and thickness of 1 mm, thus obtaining test pieces for the measurement of dielectric constant.

The relative dielectric constant (10 GHz, 25°C) and dielectric loss tangent (10 GHz, 25°C) of the obtained test pieces were measured using a dielectric constant measurement device (MS46122B network analyzer, produced by AET Inc.). The measured values were regarded as the relative dielectric constant and the dielectric loss tangent of the cured product of the epoxy resin alone. Table 2 also shows these results.

**Table 2**

| | | Ex. A | Ex. B | Ex. C | Ex. D | Ex. E | Ex. F | Ex. G | Ex. H | Ex. I | Ex. J | Comp. Ex. K | Comp. Ex. L |
|---|---|---|---|---|---|---|---|---|---|---|---|---|---|
| | Epoxy resin A | 100.0 | | | | | | | | | | | |
| | Epoxy resin B | | 100.0 | | | | | | | | | | |
| | Epoxy resin C | | | 100.0 | | | | | | | | | |
| | Epoxy resin D | | | | 100.0 | | | | | | | | |
| | Epoxy resin E | | | | | 100.0 | | | | | | | |
| Cured | Epoxy resin F | | | | | | 100.0 | | | | | | |
| product of | Epoxy resin G | | | | | | | 100.0 | | | | | |
| epoxy resin | Epoxy resin H | | | | | | | | 100.0 | | | | |
| alone | Epoxy resin I | | | | | | | | | 100.0 | | | |
| | Epoxy resin J | | | | | | | | | | 100.0 | | |
| | Epoxy resin K | | | | | | | | | | | 100.0 | |
| | Epoxy resin L | | | | | | | | | | | | 100.0 |
| | Curing accelerator A | 1.0 | 1.0 | 1.0 | | | | 1.0 | 1.0 | | 1.0 | | |
| | Curing accelerator B | | | | 2.0 | 2.0 | 2.0 | | | 2.0 | | 2.0 | 2.0 |
| Evaluation | Relative dielectric constant @10 GHz, 25°C | 2.51 | 2.49 | 2.50 | 2.38 | 2.40 | 2.49 | 2.85 | 2.87 | 2.85 | 2.83 | 2.87 | 3.18 |
| | Dielectric loss tangent @10 GHz, 25°C | 0.0085 | 0.0068 | 0.0074 | 0.0061 | 0.0062 | 0.0100 | 0.0296 | 0.0286 | 0.0268 | 0.0191 | 0.0393 | 0.0310 |

### Examples 1 to 18 and Comparative Examples 1 to 10

### Preparation of Resin Varnish

Each component was weighed to the amount shown in Table 3 (part by mass). Each weighed component and 2-butanone as an organic solvent were placed into a flask so that the solids concentration (concentration of the epoxy resin composition) was 20 mass%. The mixture was stirred at 60°C to dissolve the epoxy resin composition components in the solvent, thus obtaining a resin varnish.

### Production of Resin Composition Cured Product (Resin Film)

The resin varnish obtained above was applied to release PET (polyethylene terephthalate) so that the coating thickness after drying was 100 µm. The coated resin varnish was dried in an oven to achieve a semi-cured (B-stage) state. Additionally, release PET was stacked on the B-stage, and pressing was performed at a pressing temperature of 200°C with a heat holding time of 120 minutes and at a pressure of 2.5 MPa to achieve a cured (C-stage) state. The thus-obtained cured resin layer had a thickness of 100 µm. The release PET was removed from the laminate after pressing, thus obtaining a resin film of a resin layer alone.

### Dielectric Loss Tangent

The dielectric loss tangent of the resin film obtained above was measured in accordance with a cavity resonator perturbation method. First, the dielectric loss tangent at a frequency of 10 GHz at 25°C was measured using a network analyzer as the measurement device (ordinary state test). The same evaluation was also performed on samples that had been subjected to heat-moisture treatment by storing for 168 hours under conditions of 85°C and 85% RH (relative humidity) using an SH-261 compact environmental tester (produced by ESPEC Corp.) (high-temperature, high-humidity test). Table 3 also shows the results.

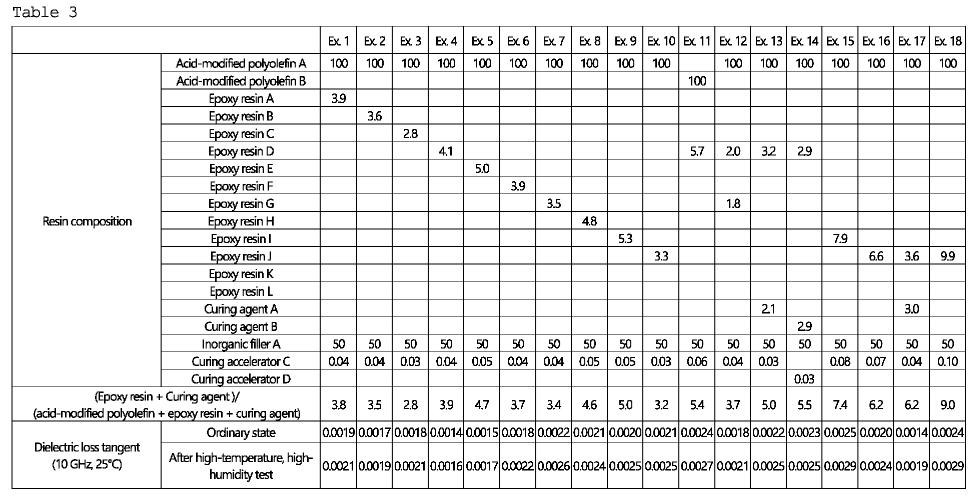

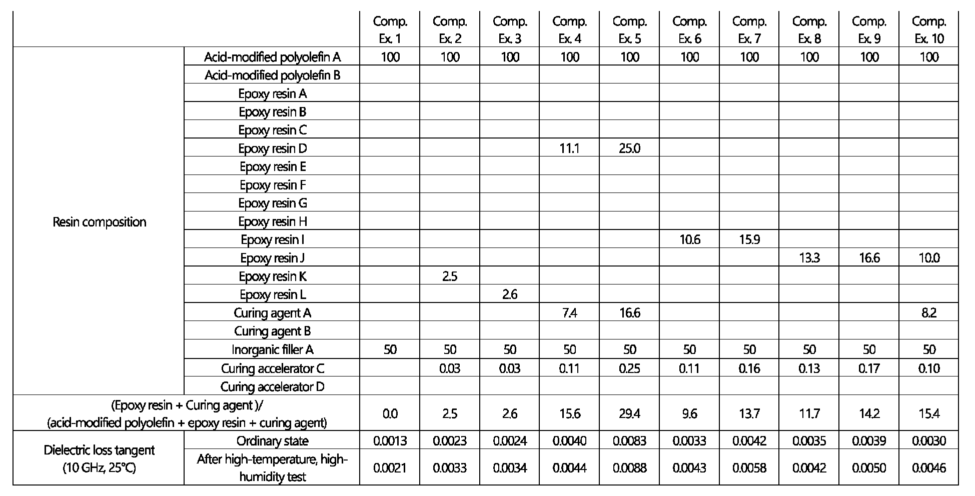

### Peel Strength (90-Degree Peel Strength Test)

Each of the resin compositions of Examples 1 to 18 was applied to the release surface side of a PET film that had been subjected to release treatment on one side, and drying was performed under conditions of 80 to 180°C for 1 to 30 minutes to achieve a semi-cured state (B stage) so that the thickness after drying was 25 µm, thus forming an adhesive layer. Accordingly, an adhesive film having the adhesive layer on the PET film was obtained.

A polyimide film with a thickness of 25 µm was laminated on the surface opposite to the surface on the PET film side of the adhesive layer, and the PET film was removed, thus obtaining a laminate having the adhesive layer on the polyimide film.

Next, the glossy surface side of rolled copper foil (product name: BHY-82F-HA-V2, thickness: 35 µm, produced by JX Nippon Mining & Metals Corporation) was laminated on the surface opposite to the surface on the polyimide film side of the adhesive layer of the laminate. Then, heating and applying pressure were performed under conditions of 180°C and 3.0 MPa for 60 minutes, thus obtaining a sample (copper foil-laminated sheet).

Additionally, a sample was obtained by laminating a polyimide film instead of the rolled copper foil, followed by heating and applying pressure under the same conditions (polyimide-laminated sheet).

Each of the samples obtained above was cut into pieces with a width of 10 mm and a length of 100 mm, and peel strength was measured in the 90° direction (orthogonal to both directions of the laminated sheet) using AGS-X (produced by Shimadzu Corporation). The measurement was performed under conditions of pulling of the substrate film with a test rate of 50 mm/min.

Table 4 shows the results.

**Table 4**

| | Ex. 1 | Ex. 2 | Ex. 3 | Ex. 4 | Ex. 5 | Ex. 6 | Ex. 7 | Ex. 8 | Ex. 9 | Ex. 10 | Ex. 11 | Ex. 12 | Ex. 13 | Ex. 14 | Ex. 15 | Ex. 16 | Ex. 17 | Ex. 18 |
|---|---|---|---|---|---|---|---|---|---|---|---|---|---|---|---|---|---|---|
| Copper foil peel strength (N/mm) | 8.6 | 8.0 | 8.2 | 7.2 | 7.4 | 8.6 | 9.1 | 8.9 | 6.7 | 9.2 | 6.6 | >10 | 6.9 | 6.6 | 8.9 | 9.2 | 8.8 | 8.0 |
| Polyimide film peel strength (N/mm) | >10 | >10 | >10 | 7.1 | 7.6 | >10 | >10 | >10 | 8.2 | >10 | 6.5 | >10 | 7.0 | 6.9 | >10 | >10 | >10 | >10 |

The results reveal that the resin compositions of the Examples all had practical adhesion.

### Soldering Heat Resistance Test

Each of the samples obtained as described above (copper foil-laminated sheet) was cut into sample pieces (60 mm x 60 mm), immersed in a solder bath at 260°C for 10 seconds, and observed in terms of the presence or absence of appearance change, such as swelling. Swelling was observed only in Comparative Example 1, and no swelling was observed in Examples 1 to 18 and Comparative Examples 2 to 10.

The above results reveal that the resin composition that did not contain an epoxy resin (Comparative Example 1) had significantly poor soldering heat resistance and was unsuitable for use in, in particular, electronic components etc.

## Claims

1. A resin composition comprising an acid-modified polyolefin, an epoxy resin, and an inorganic filler,
wherein a cured product of the resin composition has a dielectric loss tangent of 0.003 or less at a frequency of 10 GHz at 25°C after storage for 168 hours under conditions of 85°C and 85% RH (relative humidity).

2. The resin composition according to claim 1, wherein the inorganic filler is silica.

3. The resin composition according to claim 1 or 2,
wherein the epoxy resin is at least one member selected from the group consisting of bisphenol A epoxy resins, biphenyl epoxy resins, dicyclopentadiene epoxy resins, anthracene epoxy resins, and silicon element-containing epoxy resins.

4. The resin composition according to any one of claims 1 to 3, wherein the epoxy resin is an epoxy resin whose cured product has a dielectric loss tangent of 0.03 or less at a frequency of 10 GHz at 25°C.

5. The resin composition according to any one of claims 1 to 4, further comprising a curing agent.

6. The resin composition according to any one of claims 1 to 5, wherein the total mass of the epoxy resin and the curing agent is 9 parts by mass or less based on 100 parts by mass of the total mass of the acid-modified polyolefin, the epoxy resin, and the curing agent.

7. An adhesive film containing the resin composition of any one of claims 1 to 6.

8. The adhesive film according to claim 7, wherein the resin composition is a cured product and has a thickness of 2 to 200 µm.

9. A coverlay film having a laminated structure in which an adhesive layer containing the resin composition of any one of claims 1 to 6 and an electrical insulating layer are laminated.

10. A printed circuit board having a laminated structure in which an adhesive layer containing the resin composition of any one of claims 1 to 6 and an electrical insulating layer are laminated.
